# EUROPÄISCHE PATENTSCHRIFT

(11) **EP 1 220 734 B1**
(45) Veröffentlichungstag und Bekanntmachung des Hinweises auf die Patenterteilung: **05.01.2005**
(21) Anmeldenummer: 00972673.8
(22) Anmeldetag: 04.10.2000
(51) Int. Cl.: B23K 26/02, B23K 26/06, G02B 27/14, H01S 5/40

(54) **VORRICHTUNG MIT MINDESTENS EINER MEHRERE EINZEL-LICHTQUELLEN UMFASSENDEN LICHTQUELLE**
DEVICE WITH AT LEAST ONE LIGHT SOURCE, COMPRISING SEVERAL INDIVIDUAL LIGHT SOURCES
DISPOSITIF COMPRENANT AU MOINS UNE SOURCE LUMINEUSE FORMEE PAR PLUSIEURS SOURCES LUMINEUSES INDIVIDUELLES

(30) Priorität: 13.10.1999 DE 19949198
(43) Veröffentlichungstag der Anmeldung: 10.07.2002
(73) Patentinhaber: MYOS My Optical Systems GmbH, 97232 Giebelstadt (DE)
(72) Erfinder: Kleinhuber, Harald G., 06640 St. Jeannet (FR)
(74) Vertreter: Ostertag, Ulrich, Dr.
(86) Internationale Anmeldenummer: PCT/EP2000/009683
(87) Internationale Veröffentlichungsnummer: WO 2001/026859

(56) Entgegenhaltungen:
- EP-A- 0 570 152
- US-A- 4 826 269
- US-A- 4 828 357
- US-A- 5 449 882
- US-A- 5 760 872
- US-A- 5 862 278
- PATENT ABSTRACTS OF JAPAN vol. 012, no. 257 (M-719), 20. Juli 1988 (1988-07-20) & JP 63 040694 A (TOYOTA MOTOR CORP), 22. Februar 1988 (1988-02-22)

## Beschreibung

Die Erfindung betrifft eine Vorrichtung mit mindestens einer mehrere Einzel-Lichtquellen umfassenden Lichtquelle gemäß dem Oberbegriff des Anspruchs 1 (Siehe US-A-4 826 269).

Derartige Vorrichtungen finden ihren Einsatz dort, wo das Licht mehrerer Einzel-Lichtquellen z.B. zur Leistungssteigerung in einem relativ kleinen räumlichen Arbeitsbereich überlagert werden soll. Derartige Anwendungen liegen in der Materialbearbeitung, z.B. beim Laserschweißen, - schneiden oder -bohren, aber auch im Bereich der Telekommunikation, wenn in einem durch eine optische Faser realisierten Datenübertragungskanal eine hohe Lichtleistung zur Informationsübertragung über weite Strecken ohne zwischengeschaltete Verstärker erfolgen soll.

Bei bekannten derartigen Vorrichtungen eingesetzte Einzel-Lichtquellen sind Laserdioden-Arrays, die auch als Barren bezeichnet werden. Ein derartiges Laserdioden-Array weist eine Vielzahl von in einer Reihe angeordneten einzelnen Laserdioden auf. Ein Hochleistungs-Laserdioden-Array hat eine Ausgangs-Lichtleistung von etwa 50 W. Typische Emissionsflächen derartiger Laserdioden-Arrays haben eine Längsseite (lange Achse) von typ. 10 mm und eine Schmalseite (kurze Achse) von typ. weniger als 1 mm, z.B. 0,6 mm oder auch 0,02 mm. Dabei ist die Strahldivergenz des von den Laserdioden-Arrays emittierten Lichtes in den Ebenen parallel zur kurzen Achse der Emissionsfläche um typisch einen Faktor 3 größer als in den dazu senkrechten Ebenen.

Es ist bekannt, derartige Laserdioden-Arrays aufeinander in sogenannte Stacks zu stapeln. Die Emissionsbündel der einzelnen Emissionsflächen der Laserdioden-Arrays innerhalb des Stacks werden überlagert, um die Lichtleistung des gesamten Stacks zu nutzen. Hierbei ist es bekannt, jedem Einzel-Emitter innerhalb der im Stack gestapelten Laserdioden-Arrays eine Mikrolinse zuzuordnen, die das Emissionsbündel eines Einzel-Emitters kollimiert und somit die Abbildung eines Einzel-Emitters auf das Einkoppelende einer diesem zugeordneten optischen Faser ermöglicht. Auf diese Weise ist einem Laserdioden-Array oder auch einem Stack eine Vielzahl von Fasern zugeordnet, die in einem Faserbündel geführt werden können. Das Auskoppelende des Faserbündels kann dann zur Erzeugung eines Arbeits-Laserstrahlbündels abgebildet werden.

Die Handhabung eines derartigen Mikrolinsen-Arrays ist relativ kompliziert, da die Mikrolinsen nahe an die Einzel-Emitter herangeführt werden müssen und die Justage dementsprechend kritisch ist. Zusätzlich ist bei Einsatz von Mikrolinsen in Verbindung mit Hochleistungs-Laserdioden-Arrays die Herstellung und die Materialauswahl sehr kritisch, da kleinste Absorptionen bei der Emissionswellenlänge der Laserdioden zu einer nicht tolerablen Aufheizung der Mikrolinsen führen.

Daneben ist es bekannt, die Emissionsbündel von Laserdioden-Arrays mit unterschiedlichen Emissionswellenlängen über dichroitische Einkoppelspiegel zur überlagern. Dabei ergibt sich der Nachteil, daß nur Laserdioden unterschiedlicher Wellenlänge auf diese Weise überlagerbar sind.

Es ist daher die Aufgabe der vorliegenden Erfindung, eine Vorrichtung der eingangs genannten Art derart weiterzubilden, daß eine effiziente Überlagerung der Einzel-Lichtquellen mit einer kompakten optischen Anordnung mit möglichst niedrigen Verlusten und geringem Justieraufwand ermöglicht wird.

Diese Aufgabe wird erfindungsgemäß gelöst durch eine Vorrichtung mit den im Anspruch 1 angegebenen Merkmalen.

Die koaxiale Anordnung der Einzel-Lichtquellengruppe erlaubt eine Unterbringung einer Mehrzahl von Einzel-Lichtquellen relativ kompakt um das astigmatische optische Element herum. Gegebenenfalls erforderliche Versorgungsund/oder Kühlleitungen können einfach vom Strahlengang entfernt, nämlich auf der der optischen Achse abgewandten Seite der Vorrichtung geführt sein.

Der Astigmatismus des astigmatischen optischen Elements gewährleistet, daß die Abbildungseigenschaften der optischen Anordnung an die in den beiden Hauptachsen verschiedenen Strahlbündelparameter, d.h. an Bündelquerschnitt und die Divergenz, der Einzel-Lichtquellen angepaßt werden können. Einer Hauptebene des astigmatischen optischen Elements ist dabei jeweils eine Achse der Emissionsfläche einer Einzel-Lichtquelle zugeordnet. Durch das astigmatische optische Element werden die Emissionsbündel der Einzel-Lichtquellen in eine Ebene überführt, in der die Querschnittsfläche der Emissionsbündel in zwei senkrecht aufeinander stehenden Richtungen gleiche Abmessungen hat. Nachfolgend wird zur Bezeichnung dieses Sachverhalts der Begriff "gleich lange Achsen" verwendet. Diese Ebene, Ausgleichsebene genannt, kann entweder gleichzeitig die Arbeitsebene darstellen oder in eine solche abgebildet werden. Aus den die Emissionsflächen der einzelnen Einzel-Lichtquellen mit ungleich dimensionierten Achsen verlassenden Strahlenbündeln werden auf diese Weise Einzel-Lichtquellestrahlbündel mit einer Querschnittsfläche mit gleichen Achsen, die sich in der Arbeitsebene überlagern.

Das durch Überlagerung entstandene Arbeitsstrahlbündel kann dann z.B. bei der Materialbearbeitung oder auch bei einer Telekommunikations-Anwendung eingesetzt sein. Das Einsatzgebiet "Materialbearbeitung" ist dabei nicht auf Fertigungstechnik beschränkt, sondern umfaßt auch z.B. die Medizintechnik.
Die optische Vorrichtung kann mit hocheffizient bündelführenden Komponenten ausgeführt sein, so daß praktisch keine Verluste bei der Bündelführung auftreten.

Gemäß Anspruch 2 aufgebaute Einzel-Lichtquellen aus nebeneinander angeordneten Einzel-Emittern weisen Emissionsflächen mit unterschiedlich langen Achsen auf, deren Strahlungen mit dem astigmatischen optischen Element auf einfache Weise zu einem Arbeitsstrahlbündel überlagert werden können.

Die Verwendung von Laserlicht gemäß Anspruch 3 ermöglicht Arbeitsstrahlbündel mit besonders gut anpaßbaren optischem Eigenschaften und dem Potential zur Erzeugung sehr hoher Flächenleistungen. Mit Laserlicht hoher Intensität läßt sich zudem über bekannte Frequenzkonversionsverfahren eine Spektralquelle in einem gewünschten Spektralbereich realisieren.

Laserdioden gemäß Anspruch 4 sind effiziente Laser, die in hoher Anzahl auf einer relativ kleinen Fläche untergebracht werden können. Dies führt zu einem kompakten Aufbau der Vorrichtung.

Mittels eines Faserbündels gemäß Anspruch 5 kann auch die Strahlung einer beliebigen anderen Einzel-Lichtquelle bei der optischen Anordnung der Vorrichtung eingesetzt werden. Die Auskoppelbündel aus herkömmlichen optischen Fasern haben Strahlparameter, die denjenigen von Laserdioden recht ähnlich sind, so daß mit den im Prinzip gleichen Abbildungseigenschaften eines astigmatischen optischen Elements gearbeitet werden kann.

Ein Festkörperlaser gemäß Anspruch 6 ist ein kompakter Laser hoher Strahlqualität und Leistung.

Die Anordnung der Einzel-Lichtquellen gemäß Anspruch 7 führt zu einer im wesentlichen rotationssymmetrischen Vorrichtung, in der eine Mehrzahl von Einzel-Lichtquellen kompakt integriert ist. Die astigmatische Abbildung der individuellen Emissionsflächen mit unterschiedlich langen Achsen ist dabei mit einem einzigen astigmatischen optischen Element möglich.

Bei der Verwendung einer Leistungsregelungseinrichtung gemäß Anspruch 8 lassen sich die Einzel-Lichtquellen einzeln oder gruppenweise zu- oder abschalten, so daß gewollte Änderungen der Intensitätsverteilung des Arbeitsstrahlbündels z.B. durch die Kontrolle von Laserdiodenströmen durch die Leistungsregelungseinrichtung erreicht werden können. Auch Inhomogenitäten der Flächenleistungsverteilung des Arbeitsstrahlbündels lassen sich durch eine entsprechende Ansteuerung der Leistungsregelungseinrichtung ausgleichen.

Prinzipiell ist mit der erfindungsgemäßen Vorrichtung eine Überlagerung von Einzel-Lichtquellen von ein und derselben Wellenlänge möglich. Für bestimmte Anwendungen kann es jedoch vorteilhaft sein, Einzel-Lichtquellen unterschiedlicher Emissionswellenlängen gemäß Anspruch 9 einzusetzen. Derartige Anwendungen sind der wellenlängenselektive Materialschichtabtrag eines Werkstücks, der weiter unten noch näher beschrieben wird, sowie das Multiplexen von Datenübertragungskanälen in der Telekommunikation.

Ein gemäß Anspruch 10 geformtes astigmatisches optisches Element kann kostengünstig hergestellt werden, da die Krümmung in einer Abbildungsebene, nämlich der Sagittalebene, durch die Ringkrümmung vorgegeben wird. Damit ist das Schleifen der abbildenden Oberfläche des astigmatischen Elements z.B. mit einer auf einer kreisförmigen Bahn geführten Schleifkugel möglich. Eine Winkeljustierung dieses optischen Elementes gegenüber den Einzel-Lichtquellen ist nicht erforderlich.

Eine Facettierung des astigmatischen optischen Elements gemäß Anspruch 11 ermöglicht dagegen eine von der Ringform des astigmatischen optischen Elements unabhängige Krümmung der abbildenden Oberfläche. Dies führt zu einer größeren Bandbreite der anpassbaren Strahlparameter der Emissionsbündel der Einzel-Lichtquellen. Zum Beispiel ist ein astigmatisches optisches Element fertigbar, das sowohl in der Meridional- als auch in der Sagittalebene konkav gekrümmt ist. Beliebige weitere Kombinationen von konkaven bzw. konvexen Krümmungen in der Meridional- und der Sagittalebene sind möglich.

Der Einsatz eines Reflektors gemäß Anspruch 12 führt bei einer Anwendung der Vorrichtung zur Materialbearbeitung, in der ein großer Anteil des Arbeitsstrahlbündels vom Werkstück nach oben reflektiert wird, zu einer Erhöhung der Strahlungsintensität im Arbeitsbereich. Dies führt z.B. beim Beginn eines Laserschneid- oder Bohrvorgangs, dem sogenannten Einstechvorgang, zur kurzzeitigen Erhöhung der Leistungsdichte im Bearbeitungsbereich.

Bündelführende optische Komponenten mit einer zentralen Öffnung gemäß Anspruch 13 führen zur Möglichkeit des Einsatzes zusätzlicher Einrichtungen, die Steuer- und Regelvorgängen und/oder der Materialbearbeitung selbst dienen. Auch ein Justierlaser kann durch die zentrale Öffnung geführt sein. Bei koaxialer Verwendung mehrerer Lichtquellen mit zugehörigen optischen Anordnungen ist es auch denkbar, daß das Arbeitsstrahlbündel einer ersten Lichtquelle durch die zentrale Öffnung der optischen Komponenten einer zu einer zweiten Lichtquelle gehörenden optischen Anordnung hindurchgeführt wird, so daß eine Überlagerung der Arbeitsstrahlbündel mehrerer Lichtquellen möglich ist.

Die Anordnung des Reflektors gemäß Anspruch 14 führt zu dessen kompakter Unterbringung.

Durch die koaxiale Anordnung der Einzel-Lichtquellengruppe werden die Emissionsbündel der Einzel-Lichtquellen zunächst entfernt von der optischen Achse der optischen Anordnung emittiert. Verläuft der ganze Strahlengang in der optischen Anordnung bis zum Überlagerungsbereich der Emissionsbündel zum Arbeitsstrahlbündel von der optischen Anordnung gemäß Anspruch 15 entfernt, können auch die die Emissionsbündel der Einzel-Lichtquelle führenden optischen Komponenten im mittleren Bereich ausgespart sein und dadurch den freien Raum zur Verfügung stellen, der sich in unterschiedlicher Weise nutzen läßt.

Eine Sensoranordnung gemäß Anspruch 16 führt zur Möglichkeit der Überwachung des Bearbeitungsbereichs des Werkstücks. Einer derartigen Überwachung zugängliche Größen sind z.B. die Wellenlänge der vom Werkstück reflektierten oder reemittierten Strahlung, die Größe des Bearbeitungsbereichs, d.h. die Querschnittsfläche des Arbeitsstrahlbündels in der Arbeitsebene.

Unter "reflektierter Strahlung" wird solche Strahlung verstanden, die von den Einzel-Lichtquellen ausgeht und von der Werkstückoberfläche gerichtet oder diffus zurückgeworfen wird. In erster Näherung wird die nicht reflektierte Strahlung vom Werkstück absorbiert und erwärmt dieses. Daher kann der Anteil der reflektierten Strahlung ein Maß für die Temperatur des Werkstücks sein, da dieses durch die aborbierte Strahlung abhängig von der seiner Wärmeleitfähigkeit und Geometrie auf definierte Weise erwärmt wird. Die isothermischen Linien um den Bearbeitungsbereich haben eine charakteristische Form, die bei nicht gestörten Bearbeitungsprozessen in der Regel sowohl deren Lage als auch deren zeitliche Entwicklung betreffend im voraus berechnet werden können. Die Temperaturmessung erfolgt bei anderen Wellenlängen als den Emissionswellenlängen der Einzel-Lichtquellen und dient z.B. der Feststellung einer Prozeßstörung, wobei wahlweise im Bearbeitungsbereich und/oder um den Bearbeitungsbereich herum die Temperatur und ihr zeitlicher Verlauf mit mindestens einem temperaturmessenden Detektorelement erfaßt werden.

Unter "reemittierter Strahlung" wird solche Strahlung verstanden, die vom Werkstück ausgeht und durch das vom Werkstück absorbierte Licht der Einzel-Lichtquellen angeregt wird. Die Wellenlänge der reemittierten Strahlung kann z.B. zur Temperaturbestimmung des Bearbeitungsbereiches des Werkstücks herangezogen werden.

Die reflektierte Wellenlänge gibt darüber hinaus Aufschluß über Zustandsparameter der Einzel-Lichtquellen, bei Laserdioden insbesondere darüber, ob sie ausreichend gekühlt sind, da die Emissionswellenlänge von der Temperatur der Emitter abhängt.

Auch die reflektierte oder reemittierte Gesamt-Strahlungsintensität kann als Meßgröße einer Sensoranordnung sinnvoll sein, wenn z.B. der Beginn oder das Ende eines Schneidvorgangs überwacht werden sollen. Am Beginn eines Schneidvorgangs ist die reflektierte Strahlungsintensität hoch, während sie am Ende des Schneidvorgangs, d.h. dann, wenn das Arbeitsstrahlbündel das Werkstück durchdringt, schlagartig abnimmt. Die Menge der reflektierten Strahlung kann auch zur Bestimmung der Eindringtiefe des Arbeitsstrahlbündels in an und für sich bekannter Weise herangezogen werden.

Die Anordnung der Sensoranordnung in dem freien Raum um die optische Achse gemäß Anspruch 17 führt zu ihrer kompakten Integration in die Vorrichtung.

Bei einer Sensoranordnung gemäß Anspruch 18 können aus den Meßdaten, die aus dem Bearbeitungsbereich mit der Sensoranordnung gewonnen werden, Steuersignale in der Leistungsregelungseinrichtung berechnet und an die Treiber der Einzel-Lichtquellen weitergegeben werden, so daß eine Feedback-Regelung der Leistungen der Einzel-Lichtquellen zur optimierten Bearbeitungsprozeßkontrolle möglich ist.

Der Einsatz eines optischen Sensors gemäß Anspruch 19 führt zur Möglichkeit einer Meßdatenerfassung mit hoher Erfassungsrate und ist berührungslos.

Eine Sensoranordnung gemäß Anspruch 20 erweitert die Möglichkeiten einer Prozeßkontrolle. Zum Beispiel ist ein kontrollierter Materialschichtabtrag möglich, wenn die abzutragende Materialschicht sich in ihren Reflexions- bzw. Reemissionseigenschaften von der darunterliegenden Materialschicht unterscheidet. Der wellenlängenselektive Filter führt zu Möglichkeit, mit der Sensoranordnung zu unterscheiden, ob die detektierte Strtahlung noch von der abzutragenden Materialschicht oder, da sie mit anderer Wellenlänge erfolgt, schon von der darunterliegenden Materialschicht herrührt. Als Ergebnis dieser Information über die momentan bearbeitete Schicht kann z.B. die Leistungsregelungseinrichtung oder eine Fördereinrichtung für das Werkstück angesteuert werden.

Einzel-Lichtquellen unterschiedlicher Emissionswellenlängen können mit einem Filter gemäß Anspruch 21 unabhängig voneinander mit der Sensoranordnung überwacht werden. Bei Verwendung von Einzel-Lichtquellen mit z.B. zwei unterschiedlichen Emissionswellenlängen mit bekannten Ausgangsleistungen ist es möglich, durch die Messung der bei diesen Emissionswellenlängen vom Werkstück reflektierten Lichtleistung und die Verhältnisbildung der beiden diesen Lichtleistungen zugeordneten Signalen der Sensoranordnung eine spektrale Analyse des Bearbeitungsbereichs des Werkstücks basierend auf dessen unterschiedlicher Absorption bei den beiden Emissionswellenlängen durchzuführen.

Eine Sensoranordnung gemäß Anspruch 22 führt zur Möglichkeit der Überwachung von Form und Größe des Bearbeitungsbereichs. Unter einem positionsempfindlichen optischen Sensor wird dabei ein Sensor verstanden, der auf Positionsänderungen eines Objekts im Gesichtsfeld des Sensors anspricht. Mit einem derartigen Sensor ist beispielsweise die Überwachung der Qualität der Überlagerung der Emissionsbündel der Einzel-Lichtquellen im Arbeitsstrahlbündel möglich.

Ein Mehrdetektorensensor gemäß Anspruch 23 ist ein Sensor mit benachbarten lichtempfindlichen Bereichen, die unabhängig voneinander ausgewertet werden können.

Ein Quadrantendetektor gemäß Anspruch 24 ist eine besonders kostengünstige Variante eines Mehrdetektorensensors.

Ein CCD-Detektor gemäß Anspruch 25 bzw. eine CMOS-Kamera gemäß Anspruch 26 ist ein sehr empfindlicher positionsempfindlicher Sensor. Unter "CCD-Detektor" werden beliebige ein- und zweidimensionale CCD-Anordnungen verstanden.

Ein Schallwellensensor gemäß Anspruch 27 ist preiswert. Bei vielen Anwendungen insbesondere im Bereich der Materialbearbeitung ändern sich Schallwellen-Parameter in den verschiedenen Stadien der Materialbearbeitung. Werden beispielsweise gepulste Einzel-Lichtquellen mit einer bestimmten Repetitionsfrequenz eingesetzt, so kann bei dieser Frequenz empfindlich gemessen werden, ob ein Werkstück mit dem Arbeitsstrahlbündel beaufschlagt ist oder nicht. Auch bei Werkstücken, die aus verschiedenen Materialschichten aufgebaut sind, deren Schall-Abstrahlung als Reaktion auf die Beaufschlagung mit den Einzel-Lichtquellen unterschiedlich ist, ist eine Kontrolle des Materialschichtabtrags mit einem Schallwellensensor möglich.

Mittels einer Auswerteeinrichtung gemäß Anspruch 28 ist eine optimale Positionierung des Werkstücks in der Arbeitsebene möglich. Ein bekanntes Arbeitsprinzip einer derartigen elektronischen Auswerteeinrichtung ist das Triangulationsprinzip. Wenn auch eine laterale Bestimmung der Relativposition von Arbeitsbereich und Werkstück möglich ist, kann mit der Sensoranordnung und der Auswerteeinrichtung eine Nahtverfolgungseinrichtung realisiert werden.

Die Emissionsflächen der Einzel-Lichtquellen, die Einzel-Lichtquellengehäuse, die Halteeinrichtungen, auf denen die Einzel-Lichtquellen montiert sind, sowie auch die bündelführenden optischen Komponenten können sich durch thermische oder mechanische Belastung verformen. Im Extremfall wird dadurch die Qualität der Abbildung auf nicht tolerierbare Weise vermindert. Mit der Ausgleichseinrichtung gemäß Anspruch 29 werden die die Vorrichtung aufbauenden Bauelemente derart gezielt deformiert oder zueinander positioniert, daß ungewollt auftretende thermische oder mechanische Effekte kompensiert werden.

Durch eine sensorgekoppelte Steuereinrichtung gemäß Anspruch 30 ist eine automatische Kompensation der oben angesprochenen thermisch bzw. mechanisch induzierten Deformationen möglich.

Gemäß Anspruch 31 wird die Aufgabe der Überwachung der thermischen bzw. mechanischen Deformation von Bauelementen der Vorrichtung auf eine einfache Weise von der den Bearbeitungsbereich überwachenden Sensoranordnung übernommen. Thermische bzw. mechanische Deformationen führen zu einer Verformung des Arbeitsstrahlbündels, die von der Sensoranordnung insbesondere dann erfaßt werden kann, wenn sie einen positionsempfindlichen Sensor umfaßt. Die Änderung der Parameter des Arbeitsstrahlbündels, die so erfaßt werden, dienen als Ist-Werte für die Regelung der Ausgleichseinrichtung.

Alternativ kann gemäß Anspruch 32 die Deformation der Bauelemente der Vorrichtung direkt durch Wegaufnehmer gemessen werden. Als derartiger Wegaufnehmer kann beispielsweise ein optisches Interferometer dienen.

Gemäß Anspruch 33 erfolgt die gezielte Deformation von Bauelementen der Vorrichtung hydraulisch. Dadurch ist eine reproduzierbare Deformation mit hoher Genauigkeit auf relativ kostengünstigem Wege erzielbar.

Eine hydraulische Ausgleichseinrichtung gemäß Anspruch 34 ist einfach aufgebaut und arbeitet dennoch präzise.

Bei der Ausgestaltung gemäß Anspruch 35 wird eine zusätzliche Kühlfunktion der hydraulischen Ausgleichseinrichtung erzielt.

Eine Kühleinrichtung gemäß Anspruch 36 führt zu einer besonders guten Wärmeabfuhr der beim Betrieb der Vorrichtung erzeugten thermischen Energie.

Dabei verringert die Ankopplung der Einzel-Lichtquellen gemäß Anspruch 37 deren thermisch bedingte Deformation.

Der Einsatz von Keramik gemäß Anspruch 38 ist aus zwei Gründen vorteilhaft: Keramik hat nur einen geringen Wärmeausdehnungskoeffizienten und ist gleichzeitig gut wärmeleitend.

Mittels einer Überwachungseinrichtung gemäß Anspruch 39 ist die Funktion der Ausgleichs- bzw. der Kühleinrichtung gut kontrollierbar. Zustandsparameter können z.B die Temperatur des Kühlfluids, der Ionisierungsgrad, die Kühlfluiddurchflußrate sowie die Temperaturdifferenz zwischen dem Ein- und dem Auslaß des Kühlmittels sowie der Kühlmitteldruck sein.

Piezoelemente gemäß Anspruch 40 eignen sich gut zur Deformationskompensation von Bauelementen der Vorrichtung, da ihre Wirkung fein einstellbar sind. Zusätzlich zum reinen Ausgleich thermischer bzw. mechanischer Deformationen können die Piezoelemente auch zur Justage der Einzel-Lichtquellen bzw. der bündelführenden optischen Komponenten oder zur Erzeugung beliebiger Strukturen des Arbeitsstrahlbündels in der Arbeitsebene, z.B. einer Linie, eines Rings oder eines Rechtecks, herangezogen werden. Dazu werden jeder Einzel-Lichtquelle oder jeder bündelführenden Komponente Piezoelemente zugeordnet, die eine Justage in den erforderlichen Freiheitsgraden ermöglichen.

Beim Ausführungsbeispiel der Vorrichtung mit dem durchgängigen freien Raum läßt sich auf einfache Weise eine Zusatz-Lichtquelle gemäß Anspruch 41 integrieren. Mittels einer derartigen Zusatz-Lichtquelle wird zusätzlich zum Bearbeitungsbereich der Einzel-Lichtquellengruppe ein weiterer Arbeitsfokus zur Materialbearbeitung eingeführt.

Insbesondere beim Laserschweißen sind mit einer derartigen vorrichtung Arbeitsverfahren mit zwei einander nacheilenden Brennpunkten möglich, wobei die Strahlparameter der Lasergruppe und der Zusatz-Laserquelle voneinander unabhängig eingestellt werden können. Insbesondere beim Laserschneiden sind mit einer derartigen Ausgestaltung der Vorrichtung Arbeitsverfahren mit zwei bezogen auf die optische Achse übereinander liegenden Brennpunkten möglich, wobei die Strahlparameter der Einzel-Lichtquellengruppe und der Zusatz-Lichtquelle unabhängig eingestellt werden können. Hierdurch kann eine wesentlich verbesserte Schnittqualität erzeugt werden.

Der Einsatz einer Stelloptik für die Zusatz-Lichtquelle gemäß Anspruch 42 führt zu einer von der Position des Bearbeitungsbereichs unabhängigen Einstellbarkeit des Arbeitsfokus.

Durch die Ausgestaltung der Stelloptik gemäß Anspruch 43 wird eine einfache Einstellung der Fokalposition sowie der Größe des Arbeitsfokus gewährleistet.

Die Ausgestaltung einer Verstelleinrichtung gemäß Anspruch 44 ist dabei eine besonders einfache Variante, die eine Verdrehung des Arbeitsfokus um den Bearbeitungsbereichs ermöglicht.

In Kombination mit einer Positioniersteuerung gemäß Anspruch 45 ist mittels der Verstelleinrichtung eine automatische Prozeßsteuerung einer Materialbearbeitung mit zwei Brennpunkten, z.B. eines Laserschweiß-Vorgangs möglich. Diese Steuerung kann entweder anhand von gespeicherten CAD-Daten oder über eine Nahtverfolgungseinrichtung erfolgen.

Die Überwachungseinrichtung gemäß Anspruch 46 gewährleistet eine Kontrolle des mit zwei Brennpunkten erfolgenden Materialbearbeitungsvorgangs, z.B. über die Überwachung der Positionen und Größen von Arbeitsfokus und Bearbeitungssbereich sowie ggf. zusätzlich über eine Temperaturbestimmung im Arbeitsfokus bzw. im Bearbeitungsbereich oder durch Überwachung weiterer Parameter. Im Zusammenspiel mit den oben angesprochenen CAD-Daten bzw. einer zusätzlichen Programmsteuerung ist dann eine vollautomatische Materialbearbeitung möglich.

Für verschiedene Werkstück-Materialien bzw. für Werkstücke aus verschiedenen Materialschichten kann im laufenden Bearbeitungsvorgang bei der Verwendung zweier Brennpunkte eine Änderung der relativen Flächenleistungen im Arbeitsfokus sowie im Arbeitsbereich erforderlich sein. Dies wird durch die Ausgestaltung gemäß Anspruch 47 gewährleistet.

Die Verwendung eines Festkörperlasers als Zusatz-Laserquelle gemäß Anspruch 48 führt zu einem gut kontrollierbaren Arbeitsfokus.

Dabei kann bei der Ausgestaltung gemäß Anspruch 49 auch eine voluminöse Einzel-Lichtquelle (z.B. ein CO₂-Laser oder ein optisches System zur Frequenzkonversion) als Zusatz-Lichtquelle dienen, deren Strahlung über das Strahlführungssystem zur Vorrichtung geführt wird, so daß die Strahlungsleistung dort zur Verfügung steht, aber die Kompaktheit der Vorrichtung nicht beeinträchtigt wird. Neben einer optischen Faser ist als Strahlungführungssystem beispielsweise auch ein Teleskoparm denkbar, längs dem das Emissionsbündel der Zusatz-Lichtquelle der Vorrichtung zugeführt wird.

Eine Schweißanordnung gemäß Anspruch 50 führt zur Möglichkeit der Kombination zweier Schweißverfahren, z.B. eines Laserschweißverfahrens und eines Lichtbogenschweißverfahrens, zu einem Hybrid-Schweißverfahren. Die Kombination der beiden Schweißverfahren ermöglicht eine große Flexibilität bei der Materialbearbeitung.

Mit einer Fluid-Fördervorrichtung gemäß Anspruch 51 ist das Zuführen eines Schneidgases oder Schutzgases zum Bearbeitungsbereich möglich. Im ersten Fall wird z.B. beim Laserschneiden flüssiges Metall aus dem Schneidbereich zur Erhöhung der Schneideffizienz ausgetrieben. Bei einer alternativen Ausführungsform ist die Fluid-Fördervorrichtung als Saugvorrichtung ausgebildet, mit der z.B. Rauch, der bei der Materialbearbeitung entsteht und zur Verschmutzung der optischen Komponenten oder zu einer Beeinträchtigung der Bearbeitungseffizienz der Vorrichtung durch Absorption führt, abgesaugt wird.

Die Förderröhre gemäß Anspruch 52 führt das Fluid bis in einen Bereich nahe dem Bearbeitungsbereich. Dies macht bei der ersten Ausführungsform die Zufuhr von Fluid und damit das Austreiben von Material effizienter, bei der zweiten Ausführungsform das Absaugen.

Eine Düse gemäß Anspruch 53 führt zu einer gezielten Beaufschlagung des Bearbeitungsbereichs mit Fluid.

Da das Förderende dem Bearbeitungsbereich benachbart ist, ist es in der Regel einer erhöhten Temperatur sowie vom Bearbeitungsbereich hoch geschleudertem Material des Werkstücks ausgesetzt. Die Austauschbarkeit des Förderendes gemäß Anspruch 54 führt zu einer kostengünstigen Wartungsmöglichkeit der Fluid-Fördervorrichtung.

Wie oben schon erwähnt, arbeitet die Fluid-Fördereinrichtung um so effizienter, je näher das Förderende dem Werkstück ist. Mittels einer Entfernungsmeßeinrichtung gemäß Anspruch 55 kann die optimale Position des Förderendes überwacht werden.

Die Ausgestaltung der Entfernungsmeßeinrichtung gemäß Anspruch 56 ist dabei besonders einfach.

Bei der Verwendung einer Abschirmelektrode gemäß Anspruch 57 kann der Bereich des Werkstücks vorgegeben werden, der als Gegenelektrode bei der kapazitiven Entfernungsmeßung dient. Da sich die Oberfläche des Bearbeitungsbereichs als Folge der Materialbearbeitung ständig ändert, kann es zweckmäßig sein, den Gegenelektroden-Bereich auf dem Werkstück durch entsprechendes Verringern der Abschirmung der Förderröhre zu vergrößern.

Mittels einer Einrichtung gemäß Anspruch 58 ist eine derartige Größeneinstellung für die Gegenelektrode fernsteuer- bzw. automatisierbar.

Die Ausgestaltung der Abschirmelektrode gemäß Anspruch 59 ist besonders einfach.

Mittels einer Positioniereinrichtung gemäß Anspruch 60 ist die Positionierung des Förderendes fernsteuer- bzw. automatisierbar. Wird die Positioniereinrichtung derart ausgestaltet, daß auch eine laterale Einstellung des Förderendes bezüglich des Werkstücks möglich ist, läßt sich das Förderende zentral über dem Bearbeitungsbereich einstellen.

Eine Justiereinrichtung gemäß Anspruch 61 erhöht die Genauigkeit der Positioniereinrichtung.

Eine gemäß Anspruch 62 angeordnete Justier-Lichtquelle ist eine besonders einfache Justiereinrichtung. Der durch das Förderende austretende Lichtfleck, mit dem das Werkstück beaufschlagt ist, dient dabei der Justierung des Förderendes in lateraler Richtung.

Eine im sichtbaren Wellenlängenbereich arbeitende Laserdiode ist für diesen Zweck eine besonders kompakte und kostengünstige Lichtquelle (Anspruch 63).

Wird als Fluid gemäß Anspruch 64 ein Gas eingesetzt, führt dies zu einem effizienten Austreiben von überschüssigem Material aus dem Arbeitsbereich der Vorrichtung.

Gemäß Anspruch 65 lassen sich mehrere Einzel-Lichtquellengruppen so kombinieren, daß sich ihre Arbeitsstrahlbündel in einem Bearbeitungsbereich überlappen. Die koaxiale Anordnung kann dabei so geschehen, daß mehrere Einzel-Lichtquellengruppen auf unterschiedlichen Radien zur zentralen optischen Achse der optischen Anordnung angeordnet sind. Alternativ oder zusätzlich können die Einzel-Lichtquellengruppen auch in Richtung der optischen Achse gegeneinander versetzt angeordnet sein. Jeder Einzel-Lichtquellengruppe kann eine optische Anordnung zur Erzeugung des jeweiligen Arbeitsstrahlbündels zugeordnet sein.

Ausführungsbeispiele der Erfindung werden nachfolgend anhand der Zeichnung näher erläutert; es zeigen:
- Figur 1:: einen Meridionalschnitt durch eine Lasergruppe und die optischen Komponenten einer erfindungsgemäßen Vorrichtung, wobei der Strahlengang der Emissionsbündel von zwei Laserdioden-Arrays einer Lasergruppe schematisch dargestellt ist;
- Figur 2:: eine Teilansicht eines Schnitts gemäß Linie II-II in Figur 1;
- Figur 3:: eine Teilansicht eines zur Figur 1 ähnlichen Schnitts mit einem astigmatischen optischen Element, das zu demjenigen der Figuren 1 und 2 alternativ ist;
- Figur 4:: einen zu Figur 2 ähnlichen Schnitt mit einem weiteren alternativen astigmatischen optischen Element;
- Figur 5:: schematisch eine Anordnung von drei Laserdioden-Arrays auf einem einer Lasergruppe zugeordneten Haltering;
- Figur 6:: eine zur Figur 1 alternative Vorrichtung in einem Gehäuse mit einem zusätzlichen Reflexionsspiegel;
- Figur 7:: eine Ausschnittsvergrößerung von Figur 6 im Bereich eines Laserdioden-Arrays;
- Figur 8:: eine zur Figur 7 ähnliche Darstellung einer alternativen Ausführungsform der Halterung und Kühlung eines Laserdioden-Arrays.
- Figur 9:: schematisch die Komponenten einer Hydraulikeinrichtung in Verbindung mit der Ausführungsform nach Figur 8;
- Figur 10:: eine zu Figur 6 alternative Vorrichtung mit einer Sensoranordnung;
- Figur 11:: eine weitere alternative Vorrichtung mit Führungskomponenten des Emissionsbündels eines nicht zur Lasergruppe gehörenden Zusatz-Lasers;
- Figur 12 :: eine alternative Vorrichtung mit einer Schneidgas-Zuführvorrichtung;
- Figur 13:: ein schematisches Blockdiagramm einer Leistungssteuerungsschaltung für zwei Laser;
- Figur 14:: ein schematisches Blockdiagramm einer wellenlängenselektiven Materialbearbeitungs-Steuerungsschaltung für die Vorrichtung;
- Figur 15:: ein schematisches Blockdiagramm einer Positionssteuerungsschaltung für die Relativposition eines Arbeitsbereichs der Vorrichtung zu einem Arbeitsfokus der Vorrichtung; und
- Figur 16:: eine Prinzipdarstellung der Abbildungsverhältnisse bei der Abbildung eines Objekts mit einem astigmatischen optischen Element.

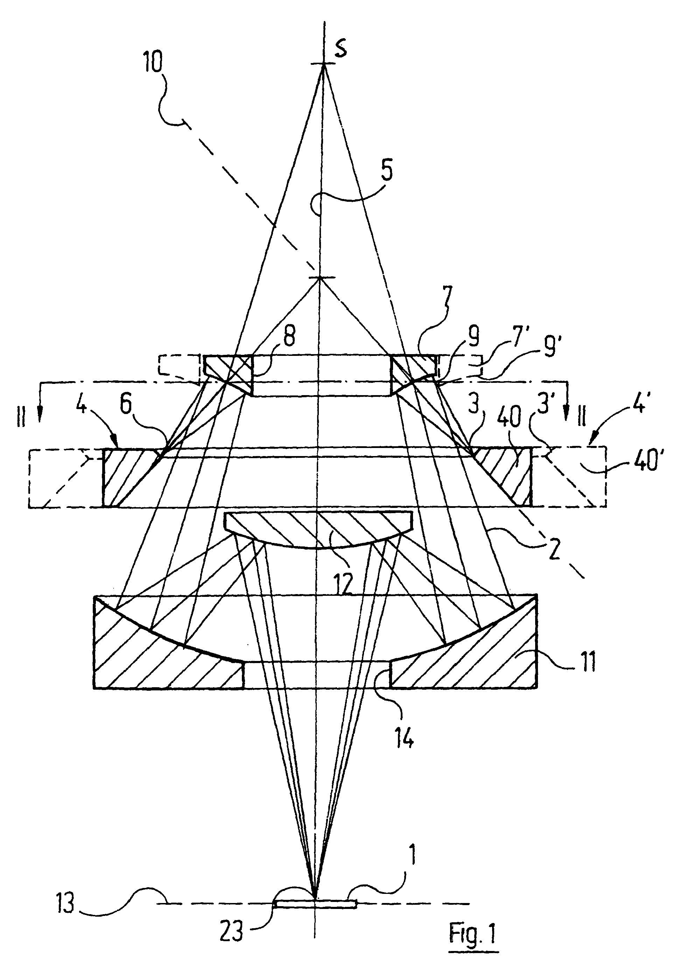

Eine Vorrichtung mit dem in Fig. 1 schematisch dargestellten Strahlengang dient der Materialbearbeitung eines in Figur 1 schematisch dargestellten Werkstücks 1 unter Zuhilfenahme von Laserlicht. Beispiele für eine derartige Bearbeitung sind Schweißen, Schneiden, Bohren, Abtragen oder Oberflächenbehandlungen wie Härten.

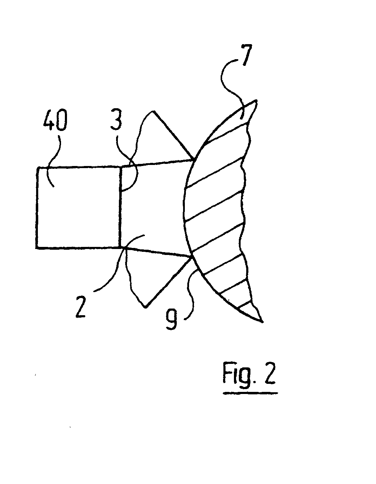

Als Materialbearbeitungslaser dienen Hochleistungs-Laserquellen, die bei einer typischen Vorrichtung eine mittlere optische Gesamt-Ausgangsleistung von mehreren hundert Watt haben, die in einem kleinflächigen Arbeitsbereich auf dem Werkstück 1 konzentriert werden muß. Zur optischen Strahlführung der Emissionsbündel 2 von Laserdioden-Arrays 3, die, wie nachfolgend noch beschrieben wird, eine Lasergruppe 4 bilden, dient der Überlagerung der Emissionsbündel 2 die in den Figuren 1 und 2 dargestellte optische Anordnung:

Die Laserdioden-Arrays 3 der Lasergruppe 4 sind auf einem ringförmigen Kühlkörper 40 koaxial um eine optische Achse 5 der optischen Anordnung angeordnet. Dieser ist in der Praxis zur leichteren Handhabung und zur einfacheren Befestigung der Laserdioden-Arrays 3 in einzelne Segmente unterteilt, die jeweils eine Mehrzahl von Laserdioden-Arrays 3 tragen und einzeln demontiert werden können. Sein Material stimmt mit demjenigen des Gehäuses des Laserdioden-Arrays 3 in seinem Wärmeausdehnungskoeffizienten überein.

In Figur 1 sind die Laserdioden-Arrays 3 schematisch als sich schließender Ring dargestellt; je nach Erfordernissen für Materialbearbeitungsvorrichtung ist die Anzahl der in diesem Ring untergebrachten Laserdioden-Arrays 3 wählbar. Typische Anzahlen, die eingesetzt werden, sind bis zu 30 Laserdioden-Arrays 3.

Die Emissionsflächen der Laserdioden-Arrays können auf den Seitenflächen eines Vielecks liegen; alternativ ist auch eine Konfiguration möglich, bei der die Emissionsflächen bogenförmig um die optische Achse 5 mit einer Krümmung verlaufen, die dem Abstand der Emissionsflächen zur optischen Achse 5 entsprechen.

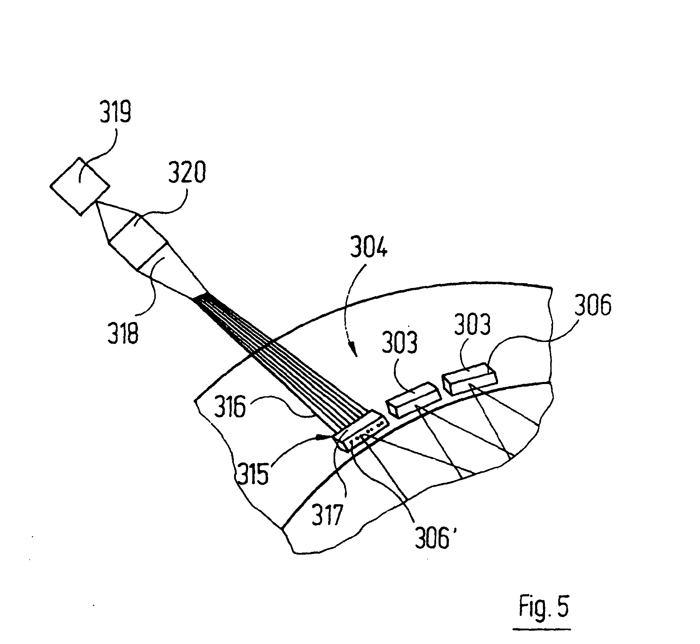

Diese Emissionsflächen (vergleiche dazu die Emissionsflächen 306 der Figur 5) der einzelnen Laserdioden-Arrays 3 sind rechteckig mit einem typischen Längenverhältnis der aufeinander senkrecht stehenden Achsen von ca. 10mm zu 0,6mm. Die lange Achse der Emissionsfläche liegt in der zur Meridionalebene der Fig. 1 (vgl. Fig. 2) gehörenden Sagittalebene, die kurze Hauptachse in der durch den Mittelpunkt der Emissionsfläche definierten Meridionalebene angeordnet (im Schnitt der Fig. 1 schematisch als punktförmiger Emitter dargestellt).

Von der Emissionsfläche eines Laserdioden-Arrays 3 tritt das Emissionsbündel 2 divergent aus und wird von einem reflektierenden astigmatischen optischen Element 7 abgebildet. Die Divergenzen des Emissionsbündels 2 sind bei bekannten Laserdioden-Arrays 3 parallel zu den Achsen der Emissionsfläche verschieden: Die Divergenz parallel zur kurzen Achse der Emissionsfläche ist dabei mehr als dreimal so groß wie diejenige parallel zur langen Achse.

Das optische Element 7 ist ringförmig mit einer zentralen Öffnung 8, die koaxial zur optischen Achse des astigmatischen optischen Elements 7 ist, die ihrerseits mit der optischen Achse 5 der optischen Anordnung zusammenfällt.

Das astigmatische optische Element 7 weist zur Abbildung des Emissionsbündels 2 eines Laserdioden-Arrays 3 eine abbildende Fläche 9 mit zwei unterschiedlichen Krümmungen auf:

In der einem Laserdioden-Array 3 zugeordneten Meridionalebene, d.h. der Ebene, die definiert ist durch die optische Achse 5 und den Mittelpunkt der Emissionsfläche 6, weist die abbildende Fläche 9 eine von außen gesehen konkave Krümmung auf und wirkt vergrößernd. In der entsprechenden Sagittalebene, die der Emissionsfläche zugeordnet ist, d.h. in der Ebene, die den vom Mittelpunkt der Emissionsfläche ausgehenden Mittelstrahl des Emissionsbündels 2 enthält und senkrecht zur erwähnten Meridionalebene ist, ist die Abbildungsfläche 9 konvex gekrümmt und wirkt verkleinernd. Die Schnittgerade einer einem Laserdioden-Array 3 zugeordneten Sagittalebene mit der entsprechenden Meridionalebene (für dieses Laserdioden-Array mit der Zeichenebene zusammenfallend) ist in Figur 1 gestrichelt dargestellt und mit dem Bezugszeichen 10 versehen.

Der Krümmungsradius der konvexen Krümmung der abbildenden Fläche 9 des astigmatischen optischen Elements 7 in den den Laserdioden-Arrays 3 zugeordneten Sagittalebenen wird durch den Radius des astigmatischen optischen Elements 7 vorgegeben. Er wird auf die konkaver Krümmung der abbildenden Fläche so abgestimmt, daß das erzeugte virtuelle Bild der Emissionsfläche in beiden aufeinander senkrecht stehenden Achsrichtungen etwa gleich groß wird.

Durch die abbildende Fläche 9 wird ein virtuelles Bild der Emissionsfläche des Laserdioden-Arrays 3 erzeugt. In Fig. 1 ist der virtuelle Bildpunkt als Schnittpunkt S der Strahlen des Emissionsbündels 2, das in der mit der Zeichenebene zusammenfallenden Meridionalebene von der abbildende Fläche 9 reflektiert wird, eingezeichnet. Er entsteht, wenn man gedanklich die Strahlen des von der abbildende Fläche 9 reflektierten Emissionsbündels 2 in der Meridionalebene entgegen der Strahlrichtung durch das astigmatische optische Element 7 verlängert. Die Strahlen schneiden sich dann im virtuellen Bildpunkt S auf der optischen Achse 5.

Auch in der Sagittalebene wird durch das astigmatische optische Element 7 ein virtuelles Bild der Emissionsfläche erzeugt. Allerdings werden die meridional verlaufenden Ränder der Emissionsfläche aufgrund des astigmatischen Charakters des optischen Elements 7 nicht in exakt derselben Fokalebene abgebildet, in welcher die sagittal verlaufenden Ränder abgebildet werden. Eine zwischen diesen beiden Fokalebenen verlaufende Ebene, die hinsichtlich der Abbildung der Ränder einen guten Kompromiß bildet, wird nachfolgend "Ausgleichsebene" genannt.

In Fig. 1 ist dargestellt, wie die vom astigmatischen optischen Element 7 reflektierten Emissionsbündel 2 der Laserdioden-Arrays 3 von einer Kombination eines sphärischen Konkavspiegels 11 und eines sphärischen Konvexspiegels 12 weiter geführt werden. Diese Kombination bildet die Ausgleichsebene in eine Arbeitsebene 13, in der das Werkstück 1 angeordnet ist, ab. Der Konkavspiegel 11 weist eine zentrale Öffnung 14 auf, die koaxial zur optischen Achse 5 verläuft und mit der Öffnung 8 im astigmatischen optischen Element 7 fluchtet. Durch die Öffnung 14 verlaufen die Emissionsbündel 2 der Laserdioden-Arrays 3 konvergent zu einem Überlagerungspunkt, auf den nachfolgend noch eingegangen wird.

Wie gestrichelt in der Figur 1 angedeutet, kann eine weitere Lasergruppe 4' vorgesehen sein, die koaxial um die oben beschriebene Lasergruppe 4 herum angeordnet ist. Zur Abbildung der Emissionsflächen der Lasergruppe 4' sind in diesem Falle ein weiteres astigmatisches optisches Element 7' sowie ggf. weitere optische Komponenten vorgesehen (nicht dargestellt).

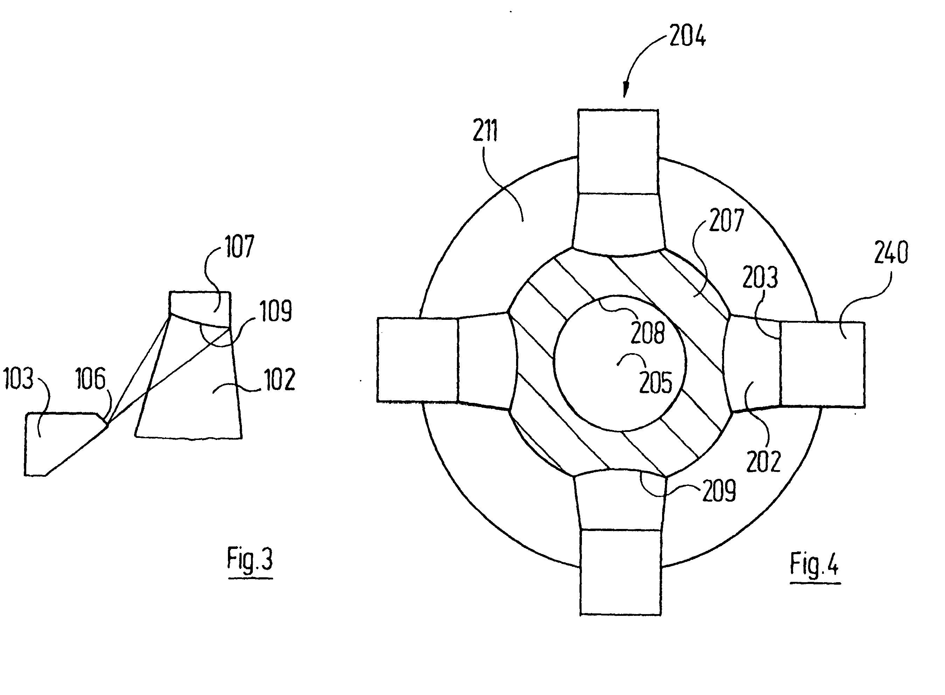

Weitere Ausführungsformen von Materialbearbeitungsvorrichtungen werden in den Figuren 3, 4 sowie 6 bis 16 beschrieben. Komponenten, die denjenigen der Figuren 1 und 2 entsprechen, erhalten mit um 100 erhöhte Bezugszeichen und werden nicht nochmals im einzelnen beschrieben.

Wie in den Figuren 3 und 4 gezeigt, können die Krümmungen der abbildenden Fläche 109 bzw. 209 des astigmatischen optischen Elements 107 bzw. 207 in den Meridional- und Sagittalebenen, die den einzelnen Laserdioden-Arrays 3 zugeordnet sind, zur Erzeugung einer Ausgleichsebene alternativ auch so ausgeführt sein, daß die Krümmung in der Meridionalebene konvex ist (vgl. Figur 3) und auch so, daß die Krümmung in der Sagittalebene konkav ist (vgl. Figur 4). Im ersten Fall wird die Emissionsfläche des Laserdioden-Arrays 103 in den beiden aufeinander senkrecht stehenden Achsrichtungen unterschiedlich verkleinert, im zweiten Fall unterschiedlich vergrößert. Ergebnis ist in beiden Fällen ein virtuelles Bild der Emissionsfläche bzw. mit etwa gleichen Seitenlängen.

Zur Realisierung einer konkaven Krümmung in der Sagittalebene weist das astigmatische optische Element 207 vier als Facetten ausgeführte abbildende Flächen 209 auf, wobei jeweils eine Facette 209 einem Laserdioden-Array 3 zugeordnet ist.

Durch die Wahl der Krümmungsradien der abbildende Fläche 9, 109 bzw. 209 läßt sich die Position der Ausgleichsebene sowie die Größe der Querschnittsfläche der Emissionsbündel 2, 102 bzw. 202 in der Ausgleichsebene einstellen.

Die Krümmungen der abbildenden Flächen 9; 109; 209 brauchen nicht konstant zu sein. Alternativ kann die abbildende Fläche 9, 109, 209 z.B. parabolisch oder eine komplexeren Funktion folgend gekrümmt sein, um bei der Einstellung der Ausgleichsebene z.B. Bildfehler auszugleichen. Auch die dem astigmatischen optischen Element 7, 107, 207 nachfolgenden optischen Komponenten können entsprechend von einer Sphäre abweichende Krümmungen aufweisen.

Die beschriebene optische Anordnung arbeitet durchgängig mit reflektierenden optischen Komponenten. In analoger Weise kann die optische Anordnung auch mit transmissiven optischen Komponenten oder auch als katadioptrisches System aufgebaut sein. Auch holographische Komponenten zur Strahlführung sind möglich.

Wie Fig. 5 zeigt, sind die Emissionsflächen 306 der Laserdioden-Arrays 303 aus einer Vielzahl, in der Praxis z.B. 1024, nebeneinander in einer Zeile angeordneten einzelnen Laserdioden aufgebaut. Die Emission jeweils einer Laserdiode der Laserdioden-Arrays 303 ist in Figur 5 schematisch dargestellt.

Die Laserdioden-Arrays 303 haben jeweils eine optische Leistung von ca. 60 W und produzieren eine thermische Verlustleistung in gleicher Größe. Die Laserdioden sind bei handelsüblichen Laserdioden-Arrays auf einem Diodenchip mit einer Dicke von 0,1 bis 0,2 mm angeordnet. Dieser Chip ist wiederum auf dem Kühlkörper zum Abführen der thermischen Energie, die beim Betrieb des Laserdioden-Arrays 303 erzeugt wird, angeordnet. Ein möglicher Aufbau eines solchen Kühlkörpers wird noch beschrieben.

Der für die Materialbearbeitungsvorrichtung eingesetzte Lasertyp ist nicht auf Laserdioden-Arrays beschränkt. Anstelle von oder gemeinsam mit Laserdioden-Arrays 303 können auch Faser-Arrays eingesetzt werden, wie z.B. das in Figur 5 gezeigte Faser-Array 315. Dieses weist eine Vielzahl von Fasern 316 auf, deren Auskoppel-Enden derart in einer wärmeleitenden Fassung 317 montiert sind, daß sie in einer Zeile nebeneinanderliegen und so eine Emissionsfläche 306' bilden. Die Längen der Achsen von letzterer entsprechen denjenigen der Emissionsflächen 306 der Laserdioden-Arrays 303.

In Einkoppel-Faserenden, die den gegenüberliegenden Abschluß der Fasern 316 bilden und als im wesentlichen rotationssymmetrisches Bündel vorliegen, wird mit einer Einkoppeloptik 320 ein Emissionsbündel 318 eines Nd:YAG-Lasers 319 eingekoppelt. Aus den Auskoppel-Enden der Fasern 316 tritt jeweils ein individuelles Emissionsbündel aus, dessen Divergenz mit der des Emissionsbündels einer Laserdiode des Laserdioden-Arrays 303 vergleichbar ist.

Die optische Leistung des fasergekoppelten Nd:YAG-Lasers 319, die aus der Emissionsfläche 306' austritt, ist vergleichbar mit derjenigen eines Laserdioden-Arrays 303, also im Bereich von 60 W.

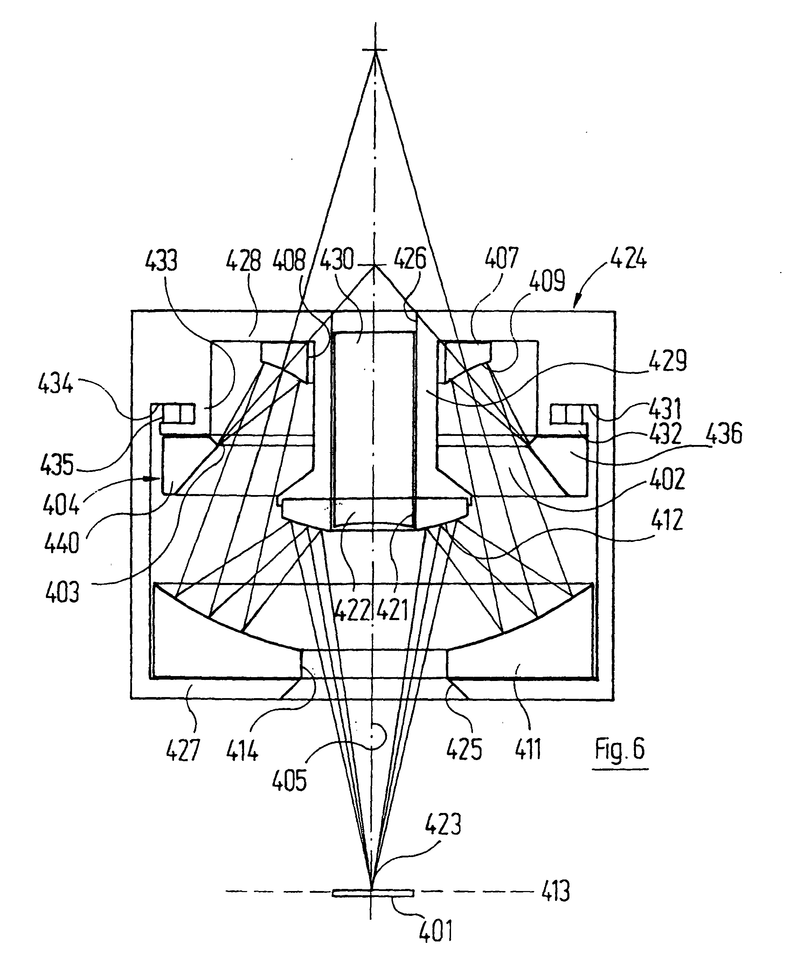

Wie aus den Strahlengängen der Emissionsbündel 2 in Figur 1 ersichtlich, wird der Mittelbereich des Konvexspiegels 12 bei der Abbildung der Emissionsbündel 2 nicht genutzt. Bei der in Figur 6 dargestellten Ausführungsform der Materialbearbeitungsvorrichtung ist in diesem nicht genutzen Mittelbereich eines Konvexspiegels 412 eine zentrale Öffnung 421 ausgebildet. In dieser ist ein konkaver Reflexionsspiegel 422 angeordnet, dessen Krümmungsradius seinem Abstand von der Arbeitsebene 413, in der das Werkstück 401 angeordnet ist, entspricht. Licht, das von einem Arbeitsbereich 423, d.h. von dem Bereich in der Arbeitsebene 413, in dem das Werkstück mit den überlagerten Emissionsbündeln 402 der Laserdioden-Arrays 403 beaufschlagt wird, in Richtung des Reflexionsspiegels 422 reflektiert wird, wird in sich zurück wieder in den Arbeitsbereich 423 reflektiert, so daß der Wirkungsgrad der Materialbearbeitungsvorrichtung, insbesondere beim Beginn eines Laserschneidvorgangs (Einstechen), erhöht ist.

Figur 6 zeigt die Anordnung der Laserdioden-Arrays 403 und der optischen Anordnung der Materialbearbeitungsvorrichtung in einem Gehäuse 424. Das Gehäuse 424 hat die Form eines Hohlzylinders, wobei in beiden Stirnwänden Öffnungen 425, 426 ausgebildet sind. Die dem Werkstück 401 zugewandte Öffnung 425 ist die Durchlaßöffnung für die Emissionsbündel 402 und fluchtet mit der zentralen Öffnung 414 des Konkavspiegels 411. Letzterer ist innen an der die Öffnung 425 umgebenden unteren Stirnwand 427 des Gehäuses 424 angebracht.

Die in der oberen Stirnwand 428 des Gehäuses 424 ausgebildete Öffnung 426 setzt sich in einer ins Innere des Gehäuse 424 ragenden Hülse 429 fort. Der Innendurchmesser der Hülse 429 entspricht der Öffnung 426; die Hülse 429 ragt in die Öffnung 421 des ringförmigen Konvexspiegels 412, der in eine Aufnahme eines sich kegelförmig erweiternden gehäuseinneren Endes der Hülse 429 eingesetzt ist. Der Reflexionspiegel 422 bildet die axiale Fortsetzung eines Halteschafts 430 gleichen Durchmessers, mit dem der Reflexionsspiegel 422 verbunden ist. Der Halteschaft 430 liegt satt in der Hülse 429, so daß durch Verschieben des Halteschafts 430 in der Hülse 429 eine axiale Justierung des Reflexionsspiegels 422 zur Einstellung seines Abstands zum Arbeitsbereich 423 möglich ist.

Das astigmatische optische Element 407 ist koaxial zur Hülse 429 angeordnet und mit der oberen Stirnwand 428 des Gehäuses 24 in folgender Weise verbunden.

Ausgehend von der oberen Stirnwand 428 des Gehäuses 424 verläuft die den Zylindermantel bildende Seitenwand 433 des hohlzylinderförmigen Gehäuses 424 zunächst als Wand mit relativ großer Stärke und verjüngt sich dann über eine Stufe 431, nach der sie im wesentlichen die gleiche Stärke hat wie die untere Stirnwand 427. Am radial innenliegenden Ende der Stufe 431 ist ein Haltering 432 über einen ebenfalls ringförmigen Steg 433 angeformt. Dabei erstreckt sich der Steg 433 auf die untere Stirnwand 427 zu, während der daran angeformte Haltering 432 um 90° abgeknickt radial nach außen verläuft, wobei zwischen der Außenseite des Halterings 432 und der Seitenwand 433 des Gehäuses 424 ein Zwischenraum verbleibt. Der Haltering 432 begrenzt dadurch mit der Stufe 431 eine horizontal im Gehäuse 424 verlaufende, sich radial nach außen öffnende Ringnut 434. In dieser ist eine Mehrzahl von Piezoaktuatoren 435 so angeordnet, daß sie sich zwischen dem Haltering 432 und dem verstärkten Abschnitt der Seitenwand 433 abstützen. Jedem Laserdioden-Array 403 ist ein Piezoaktuator 435 zugeordnet.

An einer der unteren Stirnwand 427 zugewandten Koppelfläche 436 des Halterings 432 ist der ringförmige Kühlkörper 440 befestigt, der die Laserdioden-Arrays 403 trägt.

Aus konstruktiven Gründen sind im Regelfall unterschiedliche Teile der Vorrichtung in Funktionseinheiten zusammengefaßt. So bildet z.B. die Hülse 429 eine Einheit mit dem Konvexspiegel 412 oder der Kühlkörper 440 mit dem Haltering 432 eine Einheit mit dem astigmatischen optischen Element 407.

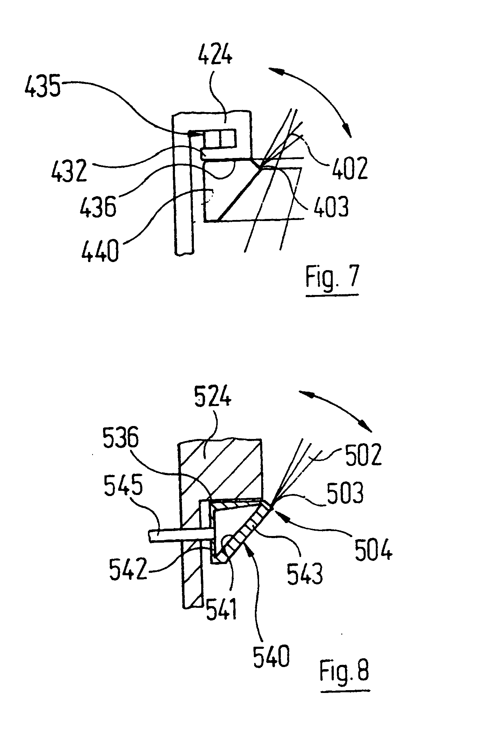

In Figur 7 ist gezeigt, daß durch eine Längenänderung eines Piezoaktuators 435 in der Richtung parallel zur optischen Achse 405 (vgl. Fig. 6) der optischen Anordnung eine Verkippung des Halterings 432 und eine resultierende Verkippung des dem Piezoaktuators 435 zugeordneten Laserdioden-Arrays 403 erfolgt. Diese Verkippung hat eine entsprechende Verkippung des Emissionsbündels 402 in der in Figur 7 gezeigten Meridionalebene zur Folge. Durch diese Verkippung steht ein Freiheitsgrad bei der Einstellung der Überlagerung der Emissionsbündel 402 der Laserdioden-Arrays 403 im Arbeitsbereich 423 zur Verfügung. Zur Einstellung weiterer ggf. erforderlicher Freiheitsgrade können weitere Piezoakutatoren mit entsprechend angepaßten Wirkungsrichtungen vorgesehen sein.

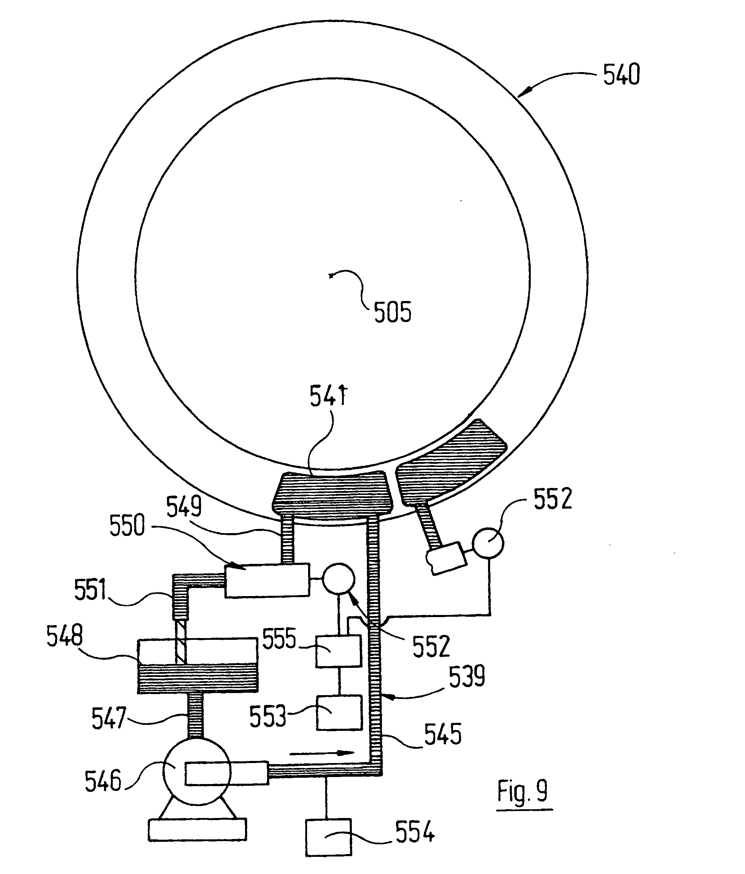

Eine alternative, hydraulische Anordnung zur Einstellung von Laserdioden-Arrays 503, mit der diese gleichzeitig gekühlt werden können, zeigen die Figuren 8 und 9. Kühlkörper 540 der Laserdioden-Arrays 503 enthalten dabei Kammern 541, die Teil eines jeweils einem Laserdioden-Array 503 zugeordneten Kühlkreislaufs 539 sind. Dieser ist in Fig. 9 für ein Laserdioden-Array 503 vollständig und für ein weiteres abschnittsweise dargestellt.

Die Kammerwände der im Querschnitt der Figur 9 im wesentlichen dreieckigen Kammer 541 im Kühlkörper 540 haben eine derartige Wandstärke, daß eine Änderung des Kühlwasserdrucks in der Kammer 541 zu einer Verkippung der Emissionsfläche des Laserdioden-Arrays 503 führt, die zu derjenigen analog ist, die beim Ausführungsbeispiel der Figur 8 durch die Piezoaktuatoren 435 bewirkt wird:

Die ringseitig äußere Mantelwand 542 des Gehäuserings 540 ist im Bereich der Kammern 541 dünn ausgeführt, so daß bei einer Erhöhung des Kühlwasserdrucks in den Kammern 541 eine Dehnung der Mantelwand 542 in einer Richtung parallel zur optischen Achse der optischen Anordnung erfolgt, die mit der Mittelachse des Kühlkörpers 540 zusammenfällt. Die der optischen Achse der optischen Anordnung schräg zugewandte, kegelförmig verlaufende Mantelwand 543 ist hingegen so stark ausgeführt, daß eine Erhöhung des Drucks in der Kammer 541 zu keiner nennenswerten Dehnung der Mantelwand 543 führt.

Die Emissionsfläche des Laserdioden-Arrays 503 kann als stirnseitiger Abschluß der Mantelwand 543 angesehen werden. Eine definierte Kippbewegung der Emissionsfläche, die sich aus dem unterschiedlichem Dehnungsverhalten der Mantelwände 542, 543 ergibt, wird dadurch gewährleistet, daß die mit der Koppelfläche 536 des Gehäuses 524 verbundene und die dritte Begrenzungsseite der dreieckigen Querschnittsfläche der Kammer 541 der Figur 9 bildende Mantelwand 544 keilförmig ausgebildet ist. Der Bereich geringster Wandstärke der Mantelwand 544 ist dabei der Emissionsfläche direkt benachbart. Dieser Bereich geringster Wandstärke gibt somit ein Scharnier bei der Verkippung der Emissionsfläche als Resultat einer Änderung des Kühlwasserdrucks in den Kammern 541 vor.

Das Kühlwasser wird den Kammern 541 über jeweils eine Zuflußleitung 545 mittels einer Hydraulikpumpe 546 zugeführt (vgl. Figur 9). Über eine weitere Leitung 547 steht die Hydraulikpumpe 546 mit einem Kühlwasserreservoir 548 in Verbindung.

Von der Kammer 541 führt eine Abflußleitung 549 über ein Proportionalventil 550 und eine weitere Leitung 551 zurück zum Kühlwasserreservoir 548. Über die Öffnungsweite des Proportionalventil 550 ist eine Einstellung des Kühlwasserdrucks in der Kammer 541 möglich. Dazu wird das Proportionalventil 550 von einer Ventilsteuerungsschaltung 552 angesteuert. Diese Ansteuerung erfolgt abhängig vom Signal einer Deformationserfassungsschaltung 555, die nachfolgend noch beschrieben wird und mit der Ventilsteuerungsschaltung 552 in Signalverbindung steht.

Die Kammern 541 werden bei der Herstellung des Gehäuserings 540 für einen vorgegebenen Nenn-Innendruck so gefertigt, daß die Einstellung der Laserdioden-Arrays 503 über das kammerdruckabhängige Verkippen der Emissionsflächen innerhalb eines weiten Kühlwasser-Druckbereichs möglich ist.

Der Bereich des angesteuerten Innendrucks der Kammern 541 liegt z.B. zwischen 5 und 15 bar.

Mit dem Kühlwasserkreislauf 539 steht eine Kühlwasser-Überwachungseinrichtung 554 in Verbindung, die die Kühlwassertemperatur, die Kühlwasserdurchflußrate, den Ionisierungsgrad des Kühlwassers sowie über entsprechende Temperatursensoren (nicht dargestellt) die Temperaturdifferenz zwischen dem Ein- und dem Auslaß des Kühlmittels überwacht. Aus diesen Daten können Kühlparameter, z.B die Kühlleistung oder der Verschmutzungsgrad des Kühlwassers, ermittelt werden. Bei Vorliegen kritischer Kühlparameter veranlaßt die Überwachungseinrichtung die Desaktivierung der Laserdioden-Arrays 503 und gibt ein Alarmsignal aus.

Der Kühlwasserkörper 540 ist aus Kupfer gefertigt. Alternativ kann er auch aus einem anderen Material, bei dem ein Wärmeleitfaktor resultiert, der größer ist als 160 W/mK. Beispielsweise ist eine Fertigung des Kühlwasserkörpers 540 aus gut wärmeleitfähiger Keramik mit einem geringen Wärmeausdehnungskoeffizienten möglich. Im Bereich der Koppelfläche 536 ist das Gehäuse 524 der optischen Anordnung aus einem Material gefertigt, das eine hohe Wärmeleitfähigkeit und den gleichen Wärmeausdehnungskoeffizienten aufweist wie das Material des Kühlwasserkörpers 540.

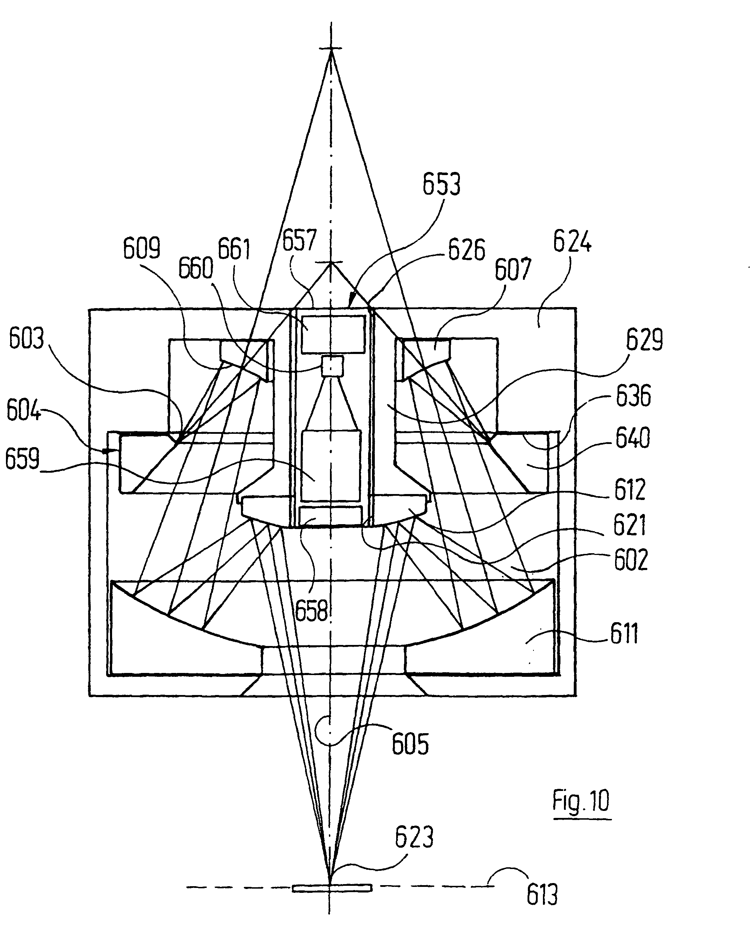

Neben der Einstellung eines Laserdioden-Arrays 503 bei der Justage der optichen Anordnung dient die in den Figuren 9 und 10 beschriebene Kammerdruck-Steuerung auch dem Ausgleich mechanischer oder thermischer Deformationen des Kühlwasserkörpers 540 insgesamt.

Mechanische Deformationen des Kühlwasserkörpers 540 können sich aufgrund des Eigengewichts oder durch bei der Montage oder als Folge eines Transports der Materialbearbeitungsvorrichtung auftretende Spannungen ergeben. Thermische Deformationen ergeben sich z.B. durch nicht rotationssymmetrische Wärmeabgabe der Laserdioden-Arrays 503 an den Kühlwasserkörper 540.

Zum Ausgleich derartiger Deformationen verarbeitet ein Rechner in der Deformationserfassungsschaltung 555 die Daten eines positionsempfindlichen Sensors 553, der Sensoren entspricht, die nachfolgend noch beschrieben werden, und gibt dementsprechend Signale an die individuellen Ventilsteuerungsschaltungen 552 der den Laserdioden-Arrays 503 zugeordneten Kühlwasserkreisläufe 539 weiter. Die durch die Änderung der individuellen Druckbeaufschlagung der Kammern 541 erfolgende Deformation des Kühlwasserkörpers 540 führt zu einer entsprechenden Repositionierung der einzelnen Emissionsflächen der Lasergruppe 504 insgesamt und über die abbildenden Eigenschaften der optischen Anordnung zu einer entsprechenden Formänderung des Bearbeitungsbereichs. Diese Formänderung wird wiederum von der Sensoranordnung 553 überwacht.

Beim beschriebenen Ausführungsbeispiel ist jeweils eine Kammer 541 einem Laserdioden-Array 503 zugeordnet. Die Anzahl der Kammern 541 kann jedoch auch sehr viel größer sein, so daß eine entsprechend höhere Genauigkeit des Deformationsausgleichs möglich ist.

Die Ausführungsform der Figur 10 zeigt ein Beispiel für eine Sensoranordnung 653, die mit der vorstehend beschriebenen Deformationssteuerung zusammenarbeiten kann. Die optische Anordnung der Materialbearbeitungsvorrichtung der Figur 10 ist in einem Gehäuse 624 untergebracht, das dem Gehäuse 424, welches im Zusammenhang mit Figur 6 beschrieben wurde, im wesentlichen baugleich ist. Lediglich die Halterung der Laserdioden-Arrays 603 ist hier durch einfaches Verbinden des Kühlkörpers 640 mit einer durch eine Gehäusestufe gebildeten Koppelfläche 636 in analoger Weise ausgeführt, wie dies im Zusammenhang mit der Figur 8 beschrieben wurde. Ein Haltering entsprechend dem Haltering 432 sowie Piezoaktuatoren entfallen somit.

In die miteinander fluchtenden zentralen Öffnungen 621, 626 des Konvexspiegels 612 bzw. der Hülse 629 ist ein Gehäuse 657 der Sensoranordnung 653 eingesteckt. Letzteres ist zum Bearbeitungsbereich 623 hin offen. Dem Bearbeitungsbereich 623 benachbart, von dem aus Strahlung in Richtung der Sensoranordnung 653 reflektiert bzw. reemittiert wird, ist im Gehäuse 657 zunächst ein wellenlängenselektiver Filter 658 angeordnet. Vom Bearbeitungsbereich 623 ab in Richtung der Sensoranordnung 653 ausgehende Strahlung wird zunächst vom Filter 658 gefiltert und gegebenenfalls von einem zusätzlichen Neutralglasfilter wellenlängenunabhängig geschwächt. Anschließend wird das gefilterte Licht von einer Abbildungsoptik 659 auf ein zweidimensionales CCD-Array 660 abgebildet. Die Abbildungsoptik 659 kann eine einzelne Linse oder auch ein vorzugsweise achromatisches Objektiv sein. Das vom CCD-Array erfaßte Bild des Bearbeitungsbereichs 623 wird in einen Speicher (nicht dargestellt) einer elektronischen Auswerteeinrichtung 661, die mit dem CCD-Array in Verbindung steht, eingelesen.

Mit Hilfe einer derartigen Sensoranordnung 653 ist eine Überwachung von Bearbeitungsparametern bei der Materialbearbeitung möglich. Über die Wellenlänge des vom Bearbeitungsbereich 623 emittierten Lichts ist z.B. eine Temperaturbestimmung des Bearbeitungsbereichs 623 möglich. Zusätzlich gibt die Ausdehnung des von der Sensoranordnung 653 überwachten Bearbeitungsbereichs 623 Aufschluß über die Abbildungsqualität der optischen Anordnung mit der Möglichkeit, diese durch eine entsprechende Einrichtung, wie z.B. oben dargestellt, zu korrigieren.

Mit dem wellenlängenselektiven Filter 658 lassen sich z.B. bei der Detektion störende Wellenlängen ausfiltern. Alternativ oder zusätzlich ist mit dem Filter 658 auch die Auswahl eines Wellenlängenbandes möglich, das selektiv auf das CCD-Array 660 abgebildet wird. Damit läßt sich die räumliche Temperaturverteilung im Bearbeitungsbereich 623 darstellen.

Beim Einsatz von Kantenfiltern als wellenlängenselektivem Filter 658 sind zusätzliche Anwendungen der Sensoranordnung 653 möglich, wie später noch beschrieben wird.

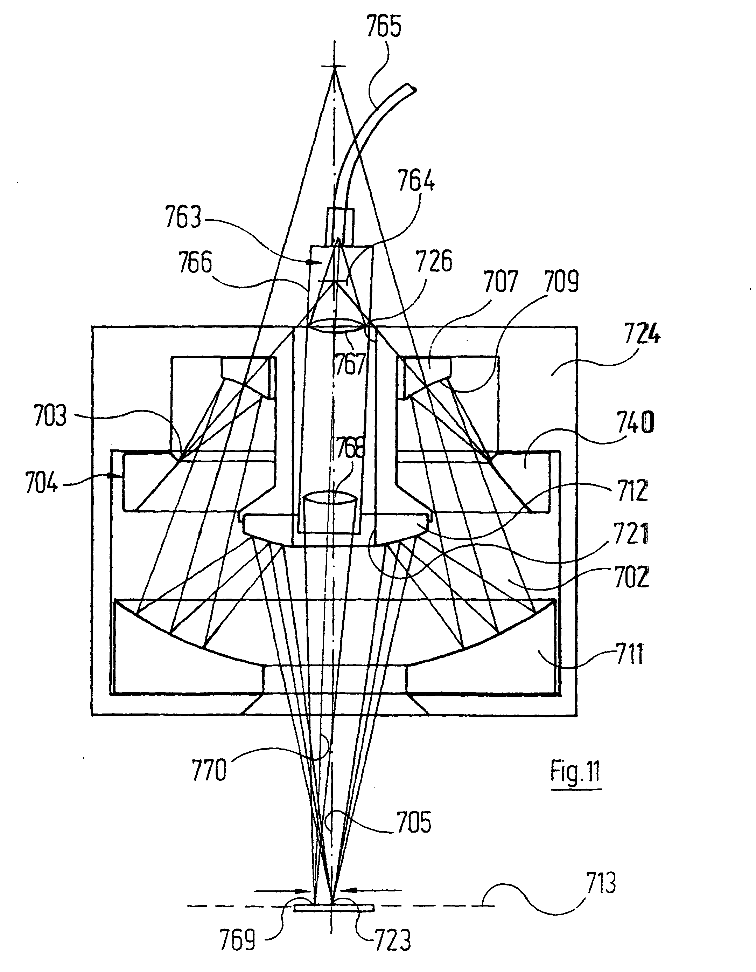

Bei der in Figur 11 dargestellten Ausführungsform der Materialbearbeitungsvorrichtung ist das Gehäuse 724 baugleich zu demjenigen der Fig. 10 ausgeführt. In den Öffnungen 721, 726 ist eine Stelloptik 763 zur Führung eines Emissionsbündels 764 eines Nd:YAG-Zusatzlasers angeordnet, der von der Lasergruppe 704 unabhängig ist. Die von dem nicht dargestellten Zusatzlaser emittierte Strahlung wird in eine optische Faser 765 eingekoppelt Das dem Gehäuse 724 zugewandte Ende der Faser 665 ist an ein Gehäuse 766 der Stelloptik 763 montiert. Das aus dem Faserende in das Gehäuse 766 austretende Emissionsbündel 764 wird von einer ersten Linse 767 kollimiert und mittels einer zweiten Linse 768 in einen Arbeitsfokus 769 des Zusatzlasers fokussiert, der in der Arbeitsebene 713 liegt, jedoch lateral vom Arbeitsbereich 723 beabstandet ist.

Die Längsachse des Gehäuses 766, die mit der optischen Achse 770 der Stelloptik 763 zusammenfällt, ist zur optischen Achse 705 der optischen Anordnung zur Abbildung der Emissionsbündel 702 der Laserdioden-Arrays 703 geneigt. Mit Hilfe eines Drehantriebs (nicht dargestellt), der am Gehäuse 766 angreift, kann die Stelloptik 763 um die optische Achse 705, also um eine Kegelmantelfläche gedreht werden. Eine derartige Drehung führt zu einer entsprechenden Wanderung des auf der optischen Achse 770 der Stelloptik 763 liegenden Arbeitsfokus 769 auf einem Kreisbogen um den auf der optischen Achse 705 der optischen Anordnung zur Abbildung der Emissionsbündel 702 liegenden Bearbeitungsbereich 723.

Mit einer weiteren nicht dargestellten Stellvorrichtung ist zusätzlich der Neigungswinkel der Längsachse des Gehäuses 766 zur optischen Achse der optischen Anordnung zur Abbildung der Emissionsbündel 702 und damit der Abstand des Arbeitsfokus 769 des Zusatzlasers vom Bearbeitungsbereich 723 einstellbar.

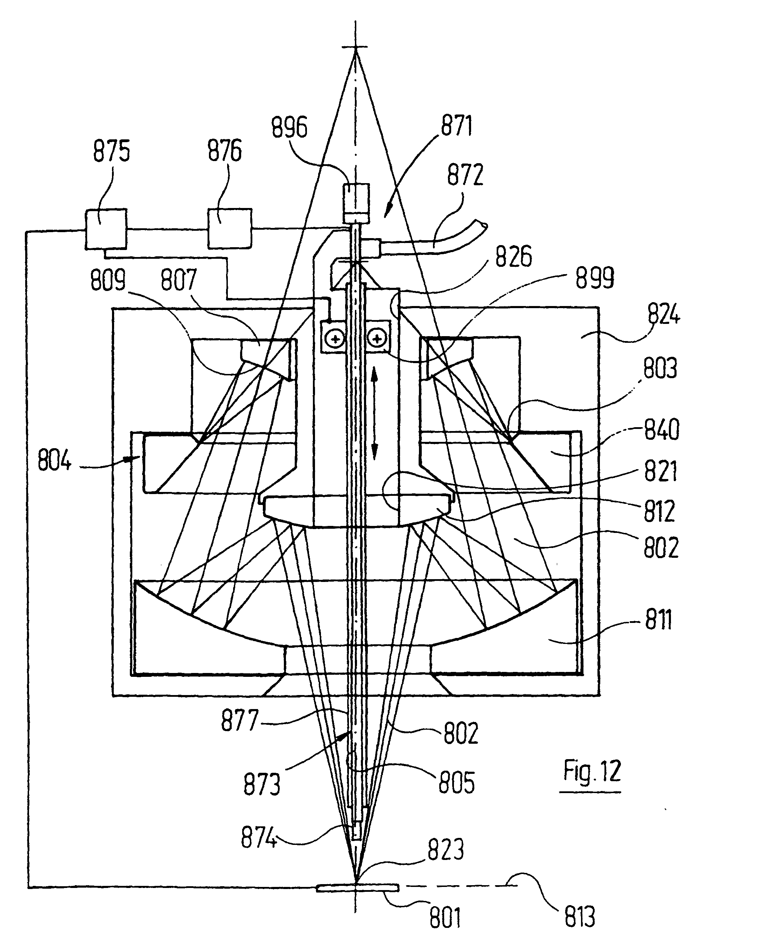

Die in Figur 12 dargestellte Ausführungsform einer Materialbearbeitungsvorrichtung zeigt wiederum eine optische Anordnung zur Abbildung der Emissionsflächen von Laserdioden-Arrays 803 auf einen Bearbeitungsbereich 823 in einem Gehäuse, das mit denjenigen der im Zusammenhang mit den Figuren 10 und 11 beschriebenen Ausführungsformen baugleich ist. In den Öffnungen 821, 826 sowie in dem an diese Öffnungen 821, 826 in Richtung des Bearbeitungsbereichs 823 anschließenden von Emissionsbündeln 802 freien Raum ist eine Schneidgas-Zuführvorrichtung 871 angeordnet. Diese weist eine Schneidgas-Zuführleitung 872 auf, in der Schneidgas von einer Schneidgas-Quelle (nicht dargestellt) herangeführt wird. Mit der Schneidgas-Zuführleitung 872 steht ein Metallrohr 873 in Fluidverbindung, das längs der optischen Achse 805 angeordnet ist. Das Metallrohr 873 mündet in eine Gasdüse 874 aus, die dem Bearbeitungsbereich 823 benachbart ist. Mit dem Metallrohr 873 und dem Werkstück 801 ist eine Kapazitäts-Meß/Regeleinrichtung 875 elektrisch verbunden, die wiederum in Signalverbindung mit einer nur schematisch dargestellten Stellvorrichtung 876 steht. Mit dieser ist eine Axialbewegung des Metallrohrs 873 möglich, wodurch der Abstand zwischen der Gasdüse 874 und dem Werkstück 801 eingestellt wird.

Bis auf den Bereich in der Nachbarschaft der Gasdüse 874 ist das Metallrohr 873 von einer hülsenförmigen Abschirmelektrode 877, die das Metallrohr 873 koaxial umgibt, abgedeckt. An der äußeren Mantelfläche der Abschirmelektrode 877 liegen an gegenüberliegenden Seiten zwei miteinander elektrisch verbundene Hochspannungskontakte einer Hochspannungselektrode 899 an.

Zur Justierung der Gasdüse 874 derart, daß der zugeführte Schneidgasstrahl möglichst effizient mit dem Arbeitsbereich 823 überlappt, ist eine Laserdiode 896 vorgesehen, deren Strahlung über ein Fenster so in das Metallrohr 873 eingekoppelt wird, daß ihr Emissionsbündel auf der zentralen Achse des Metallrohrs 873 liegt. Das Emissionsbündel tritt durch die Gasdüse 874 in Richtung des Arbeitsbereichs 823 aus und kann daher zur lateralen Justierung des Auftreffpunktes des Schneidgases auf dem Werkstück 801 relativ zum Bearbeitungsbereich 823 verwendet werden. Für diese Justage kann auch die Emission eines entsprechenden Justierlasers (nicht dargestellt) in den Strahlengang der Laserdioden-Arrays 803 eingekoppelt sein, so daß die Strahlung dieses Justierlasers das Arbeits-Laserstrahlenbündel vorgibt und die Strahlung der Laserdiode 896 mit der Strahlung dieses Justierlasers überlagert werden kann.

Die Schneidgas-Zuführvorrichtung 871 funktioniert folgedermaßen:

Zum Austreiben von geschmolzenem Metall im Zuge eines Schweißvorganges, der von der Materialbearbeitungsvorrichtung durchgeführt wird, wird Schneidgas durch die Zufuhrleitung 872 und das Metallrohr 873 über die Gasdüse 874 dem Bearbeitungsbereich 823 zugeführt. Die Gaszufuhr erfolgt dabei mit so hohem Druck, daß die flüssigen Metallanteile aus dem Bearbeitungsbereich 823 herausgetrieben werden. Je exakter die Gasdüse 874 über dem Bearbeitungsbereich 823 liegt und je näher die Gasdüse 874 dem

Werkstück 801 ist, ohne dabei in den Strahlengang der Emissionsbündel 802 einzutreten, desto effizienter erfolgt dieses Austreiben flüssigen Metalls.

Zur Optimierung der Arbeitseffizienz der Schneidgas-Zuführvorrichtung 871 wird einerseits die laterale Position der Gasdüse 874 über dem Bearbeitungsbereich 823 mit der Strahlung der Laserdiode 896 vorjustiert und andererseits der Abstand der Gasdüse 874 vom Werkstück 801 kapazitiv geregelt. Die Kapazitäts-Meß/Regeleinrichtung 875 überwacht dabei die Kapazität, die aus dem Metallrohr 872 und dem Werkstück 801 gebildet wird. Eine bestimmte Kapazität entspricht dabei einem bestimmten Abstand zwischen der Gasdüse 874 und dem Werkstück 801. Eine vorgegebene Soll-Kapazität wird von der Kapazitäts-Meß/Regeleinrichtung 875 durch entsprechendes Ansteuern der Stellvorrichtung 876, die den Abstand zwischen Gasdüse 874 und Werkstück 801 ändert, nachgeregelt.

Bei einer weiteren, nicht dargestellten Ausführungsform der Materialbearbeitungsvorrichtung ist eine Schutzgas-Zuführvorrichtung (vgl Zuführvorrichtung 871 in. Figur 12) in Form eines Rohres durch die Öffnungen 821, 826 der optischen Anordnung hindurchgeführt, welches eine Lichtbogen-Metallelektrode umgibt. Mit Hilfe einer derartigen Metallelektrode ist die Kombination eines Laserschweiß-Vorgangs durch die Laserdioden-Arrays 803 mit einem Lichtbogenschweiß-Vorgang zu einem Hybridschweißverfahren möglich. Die Metallelektrode wird dabei zum Lichtbogenschweißen in Richtung des Arbeitsbereichs 823 geführt. Sie liegt gegenüber dem Werkstück 801 auf Hochspannungspotential und schmilzt während des Schweißvorgangs an dem dem Werkstück 801 zugewandten Ende ab.

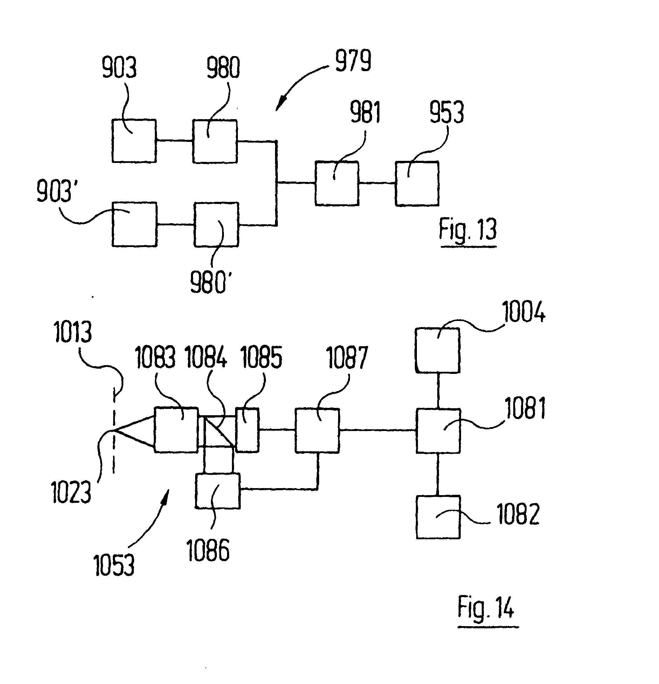

Das schematische Blockdiagramm der Figur 13 zeigt eine Laser-Leistungssteuerung 979, die zur Leistungssteuerung der Strahlungsleistungen der Laser 903 innerhalb einer Lasergruppe oder zur Leistungssteuerung der Strahlungsleistungen von zu verschiedenen Lasergruppen gehörenden Lasern jeweils gemeinsam oder zur Leistungssteuerung der Strahlungsleistung verschiedener Laserquellen, z.B. einer Lasergruppe und einem Zusatzlaser, einer Materialbearbeitungsvorrichtung eingesetzt werden kann. Exemplarisch ist die Funktion für zwei Laser 903, 903' dargestellt, die jeweils von zugeordneten Treibern 980, 980' mit elektrischer Energie versorgt werden. Beide Treiber 980, 980' stehen in Signalverbindung mit einer Leistungssteuereinheit 981. Letztere steuert die Treiber 980, 980' an.

Die Leistungsbeeinflussung durch die Leistungssteuereinheit 981 kann als Reaktion auf die Übermittlung von Signalen einer den Bearbeitungsbereich überwachenden Sensoranordnung 953 oder infolge einer direkten Benutzereingabe oder im Rahmen eines vorprogrammierten Ablaufs erfolgen.

Das schematische Blockdiagramm der Figur 14 zeigt eine wellenlängenselektive Materialbearbeitungs-Steuerungsschaltung bei Verwendung einer Lasergruppe 1004 und eines Zusatzlasers 1082. Licht der beiden entsprechenden Wellenlängen, das von einem Bearbeitüngsbereich 1023 reflektiert wird, wird von einer optischen Einrichtung 1083, z.B. einer Linse oder einem Objektiv, kollimiert. Anschließend trifft es auf einen dichroitischen Strahlteiler 1084, der die verschiedenen Wellenlängen des vom Bearbeitungsbereich 1023 ausgehenden Lichts transmittiert bzw. reflektiert. Der vom dichroitischen Strahlteiler 1084 transmittierte Anteil wird von einem Detektor 1085 erfaßt, während der reflektierte Anteil von einem Detektor 1086 erfaßt wird.

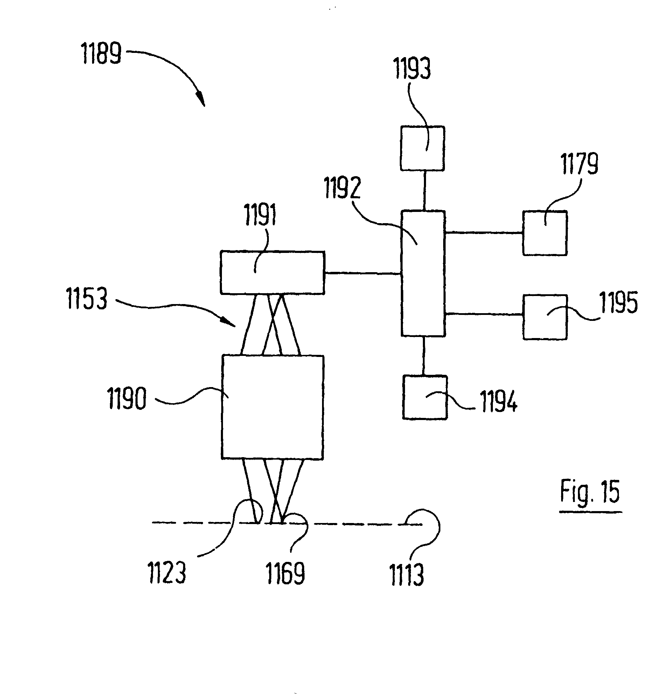

Eine Signalverarbeitungseinrichtung 1087 bildet das Verhältnis der beiden Ausgangssignale der Detektoren 1085, 1086. Abhängig vom Ergebnis dieser Verhältnisbildung gibt die Signalverarbeitungseinrichtung 1087 ein Signal an eine Leistungssteuereinheit 1081 weiter. Letztere steuert die Treiber der Lasergruppe 1004 bzw. des Zusatzlasers 1082, die in Figur 15 nicht gezeigt sind, in Abhängigkeit von dem von der Signalverarbeitungseinrichtung 1087 übermittelten Signal an.

Im Rahmen einer Materialbearbeitung, bei der ein selektiver Abtrag einer Materialschicht eines Werkstücks erwünscht ist, arbeitet die Materialbearbeitungs-Steuerung von Fig. 14 wie folgt:

Solange der Bearbeitungsbereich 1023 der Materialbearbeitungsvorrichtung noch vollständig in der oberen, abzutragenden Materialschicht liegt, geht von diesem Strahlung derjenigen Wellenlänge aus, die charakteristischerweise von der oberen Materialschicht reflektiert wird. Beginnt beim Materialabtrag im Zuge der Materialbearbeitung der Bearbeitungsbereich 1023 in eine untere, nicht abzutragende Materialschicht, die sich in ihren Eigenschaften von der oberen Materialschicht unterscheidet, einzudringen, werden der vom Bearbeitungsbereich 1023 ausgehenden Strahlung Anteile mit solcher Wellenlänge beigemischt, die charakteristischerweise von der unteren Materialschicht reflektiert wird. Insbesondere das abgestrahlte Strahlungsspektrum beginnt nun, für die zweite Materialschicht charakteristische Wellenlängenanteile aufzuweisen.

Mit dem dichroitischen Strahlteiler 1084 wird Strahlung mit Wellenlängenanteilen, die für die untere Materialschicht charakteristisch sind, auf den Detektor 1086 reflektiert. Vom dichroitischen Strahlteiler 1084 auf den Detektor 1085 durchgelassen wird hingegen nur Strahlung mit Wellenlängenanteilen, die nicht von der unteren Materialschicht ausgehen. Mit zunehmendem Anteil der Strahlung der unteren Materialschicht nimmt das Signal des Detektors 1086 zu und das Signal des Detektors 1085 ab.

Das Verhältnis der Signale der Detektoren 1085 und 1086, das von der Signalverarbeitungseinrichtung 1087 gebildet wird, nimmt daher mit zunehmender Eindringtiefe des Bearbeitungsbereichs in die untere Materialschicht ab. Durch eine geeignete Schwellwertvorgabe, mit der das gebildete Signalverhältnis in der Signalverarbeitungseinrichtung 1087 verglichen wird, kann somit diese Eindringtiefe zur Realisierung eines kontrollierten Materialschichtabtrags vorgegeben werden. Dazu werden in Abhängigkeit von der Erreichung des Schwellwerts die Treiber der Lasergruppe 1004 bzw. des Zusatzlasers 1082 heruntergefahren oder das Werkstück mit einer Fördereinrichtung lateral zur optischen Achse in der Arbeitsebene 1013 weiterbewegt.

Alternativ zur Verwendung eines dichroitischen Strahlteilers mit zwei Detektoren kann auch wie folgt vorgegangen werden:

Detektiert wird dabei mit einem einzigen Detektor, der Pulse der Laser empfängt. Ein Laser kann z.B. kontinuierlich (cw-Modus) betrieben werden, der andere gepulst (Puls-Modus). Alternativ können beide Laser im Puls-Modus arbeiten, wobei die Pulse zu unterschiedlichen Zeitpunkten ausgestrahlt werden. Die Erfassung des Detektors wird auf die zeitliche Abgabecharakteristik der Laser synchronisiert. Nach der sequentiellen Erfassung der Refleximpulse werden die erfaßten Signale abgespeichert und der Signalverarbeitungseinrichtung zugeführt.

In Fällen, in denen die unterschiedlichen Materialschichten mit Reemissionen charakteristischer Wellenlänge reagieren, kann auch mit einem einzigen Laser gearbeitet werden.

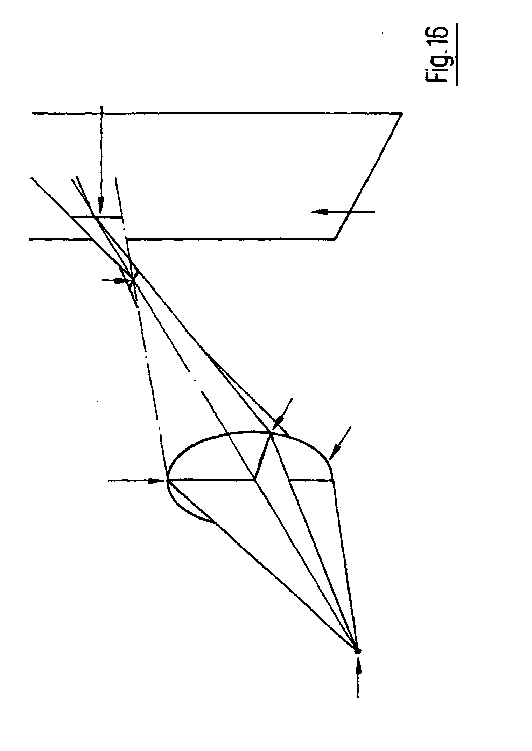

Die schematische Blockdarstellung der Figur 15 zeigt eine Positionssteuerung 1189, die Teil einer Bearbeitungssteuerung ist, die z.B. in Zusammenhang mit der Materialbearbeitungsvorrichtung der Figur 11 eingesetzt werden kann. Eine Abbildungsoptik 1190 bildet vom Werkstück 1101 ausgehende Strahlung auf einen positionsempfindlichen Detektor 1191, z.B. ein zweidimensionales CCD-Array, ab. In Figur 16 ist Strahlung eingezeichnet, die von einem Arbeitsbereich 1123, d.h. dem Bereich, in dem das Werkstück 1101 von der Strahlung einer Lasergruppe beaufschlagt ist, und einem Arbeitsfokus 1169, d.h. dem Bereich des Werkstücks, der von einem Zusatzlaser beaufschlagt wird, ausgeht.

Die Meßwerte des positionsempfindlichen Detektors 1191 werden an eine Überwachungseinrichtung 1192 weitergeleitet, die aus diesen Signaldaten die Koordinaten des Arbeitsbereichs 1123 und des Arbeitsfokus 1169 bestimmt und diese mit Soll-Koordinaten vergleicht. Die Soll-Koordinaten liegen entweder als vorgegebene Koordinaten einer Programmsteuerung 1193 vor, die mit der Überwachungseinrichtung 1192 in Signalverbindung steht, oder ergeben sich während der Materialbearbeitung aus Koordinaten des Werkstücks, die von einem zusätzlichen Sensor 1194, der mit der Überwachungseinrichtung 1192 ebenfalls in Signalverbindung steht, übermittelt werden. Der Sensor 1194 kann z.B. eine Kamera sein, die den momentanen Materialbearbeitungsbereich des Werkstücks und dessen Umgebung erfaßt.

Aus den vom positionsempfindlichen Detektor 1191 gemessenen Koordinaten und den Soll-Koordinaten berechnet die Überwachungseinrichtung 1192 Steuersignale für eine Leistungssteuerungsvorrichtung 1179 (vgl. Leistungssteuerung 979 der Figur 13) sowie eine Verstelleinrichtung 1195 zur Einstellung der Relativposition zwischen dem Arbeitsbereich 1123 und dem Arbeitsfokus 1169, z.B. durch Verstellen einer Stelloptik (vgl. Stelloptik 763 der Figur 11).

Eine derartige Positionssteuerung 1189 ermöglicht es z.B., daß bei einem Laserschweißvorgang mit zwei Brennpunkten zum Schweißen von zweidimensionalen Konturen die Lage des dem Arbeitsbereich 1122 nach- oder voreilenden Arbeitsfokus 1169 um die optische Achse der optischen Anordnung beliebig orientiert werden kann. Zusätzlich kann die Positionssteuerung 1189 eine bekannte Nahtverfolgungseinrichtung beinhalten.

Bei der oben in Zusammenhang mit den Figuren 1 bis 4 erfolgten Beschreibung der Abbildungseigenschaften des astigmatischen optischen Elements 7; 107; 207 wurde davon ausgegengen, daß die Bildgrößen der Achsen der Emissionsflächen gleich groß sind. Dies ist jedoch keine notwendige Voraussetzung, um in einer Ausgleichsebene ein Arbeits-Laserstrahlbündel mit einer Querschnittsfläche mit im wesentlichen gleich langen Achsen zu erzielen, wie nachfolgend gezeigt wird:

Wie in der Prinzipdarstellung der Figur 5 gezeigt, fallen die Bildebenen in den Hauptebenen eines astigmatisch abbildenden optischen Elements (bei einem von der optischen Achse entfernten abzubildenden Objekt sind die Hauptebenen identisch mit der Meridional- und der Sagittalebene) bei der Abbildung eines in Figur 5 schematisch als Punkt dargestellten Objekts in der Regel auseinander, so daß die beiden Achsen eines Objektes in unterschiedlichen Bildebenen scharf abgebildet werden.

Zwischen diesen beiden Bildebenen, d.h. in dem Bereich, in dem die Bündel des hinter dem astigmatischen Elements zunächst abgebildeten Bildes in der ersten Hauptebene wieder auseinanderlaufen, während das Bündel in der dazu senkrechten zweiten Hauptebene noch konvergent verläuft, nähern sich die Querausdehnungen der den Hauptebenen zugeordneten Bündel in den beiden zueinander senkrechten Richtungen einander an. Insbesondere läßt sich auch hier eine Ausgleichsebene zwischen den beiden Bildebenen angeben, bei der unabhängig von der Größe der abgebildeten Bilder in den beiden Hauptebenen die Querausdehnungen der Bündel im wesentlichen gleich sind.

## Patentansprüche

1. Vorrichtung mit mindestens einer mehrere Einzel-Lichtquellen (3, 3'; 103; 203; 303, 319; 403; 503; 603; 703; 803; 903, 903') umfassenden Lichtquelle und einer optischen Anordnung, welche aus den Emissionsbündeln der Einzel-Lichtquellen (3, 3'; 103; 203; 303, 319; 403; 503; 603; 703; 803; 903, 903') durch Überlagerung ein Arbeitsstrahlbündel hoher Flächenleistung erzeugt, wobei
a) mindestens zwei Einzel-Lichtquellen (3, 3'; 103; 203; 303, 319; 403; 503; 603; 703; 803; 903, 903') eine Emissionsfläche mit unterschiedlich langen, senkrecht aufeinander stehenden Achsen aufweisen;
b) mindestens zwei Einzel-Lichtquellen (3, 3'; 103; 203; 303, 319; 403; 503; 603; 703; 803; 903, 903') mindestens eine koaxial zur optischen Achse (5; 205; 405; 505; 605; 705; 805) eines astigmatischen optischen Elements (7, 7'; 107; 207; 407; 607; 707; 807), das von den Emissionsbündeln der Einzel-Lichtquellen (3, 3'; 103; 203; 403; 603; 703; 803; 903, 903') beaufschlagt ist, angeordnete Einzel-Lichtquellengruppe (4, 4'; 204; 304; 404; 604; 704; 804) bilden;
c) jeweils eine Achse der Emissionsfläche (306, 306') einer Einzel-Lichtquelle (3, 3'; 103; 203; 403; 603; 703; 803; 903, 903') in einer durch den Mittelpunkt der Emissionsfläche (306, 306') definierten Meridionalebene des astigmatischen optischen Elements (7, 7'; 107; 207; 407; 607; 707; 807) und die andere Achse der Emissionsfläche (306, 306') in der entsprechenden Sagittalebene des astigmatischen optischen Elements (7, 7'; 107; 207; 407; 607; 707; 807) liegt;
d) das astigmatische optische Element (7, 7'; 107; 207; 407; 607; 707; 807) in den den Emissionsflächen (306, 306') der jeweiligen Einzel-Lichtquellen (3, 3'; 103; 203; 403; 603; 703; 803; 903, 903') zugeordneten Meridional- und Sagittalebenen unterschiedliche Abbildungseigenschaften derart hat, daß jedes Emissionsbündel (2; 102; 202; 402; 502; 602; 702; 802) der Einzel-Lichtquellen (3, 3'; 103; 203; 403; 603; 703; 803; 903, 903') im Strahlengang nach dem astigmatischen optischen Element (7, 7'; 107; 207; 407; 607; 707; 807) in mindestens einer Ausgleichsebene (13; 413; 613; 713; 813; 1013; 1113), die senkrecht zur optischen Achse (5; 205; 405; 505; 605; 705; 805) des astigmatischen optischen Elements (7, 7'; 107; 207; 407; 607; 707; 807) steht, eine Querschnittsfläche mit im wesentlichen gleich langen Achsen aufweist; und
e) alle Emissionsbündel (2; 102; 202; 402; 502; 602; 702; 802) von bündelführenden Komponenten (7, 11, 12, 7'; 107; 207, 211; 407, 411, 412; 607, 611, 612; 707, 711, 712; 807, 811, 812) in eine Arbeitsebene (13; 314; 613; 713; 813; 1013; 1113) geführt werden, die entweder von der Ausgleichsebene oder einer allen Strahlenbündeln gemeinsamen Bildebene gebildet wird.

2. Vorrichtung nach Anspruch 1, **dadurch gekennzeichnet, daß** die Einzel-Lichtquellengruppe (4, 4'; 204; 304; 404; 604; 704; 804) Einzel-Lichtquellen (3, 3'; 103; 203; 303, 319; 403; 603; 703; 803; 903, 903') umfaßt, die eine Mehrzahl von insbesondere in einer Reihe nebeneinander angeordneter Einzel-Emitter aufweisen, die individuelle Emissionsbündel emittieren.

3. Vorrichtung nach Anspruch 1 oder 2, **dadurch gekennzeichnet, daß** mindestens eine Einzel-Lichtquelle (3, 3'; 103; 203; 303, 319; 403; 503; 603; 703; 803; 903, 903') ein Laser ist.

4. Vorrichtung nach Anspruch 3, **dadurch gekennzeichnet, daß** mindestens ein Teil der Einzel-Emitter Laserdioden sind.

5. Vorrichtung nach einem der Ansprüche 2 bis 4, **dadurch gekennzeichnet, daß** mindestens ein Einzel-Emitter durch die Auskoppel-Faserenden eines Faserbündels (315) mit rechteckiger Emissionsfläche (306') gebildet ist, das optisch an ein Emissionsbündel (318) einer Lichtquelle (319) angekoppelt ist.

6. Vorrichtung nach einem der Ansprüche 2 bis 5, **dadurch gekennzeichnet, daß** mindestens ein Laser ein Festkörperlaser (319; 1082) ist.

7. Vorrichtung nach einem der vorhergehenden Ansprüche, **dadurch gekennzeichnet, daß** die Emissionsflächen (306, 306') der Einzel-Lichtquellen (3, 3'; 103; 203; 303, 319; 403; 603; 703; 803; 903, 903') ein Vieleck bilden, deren Mittelachse mit der optischen Achse (5; 205; 405; 505; 605; 705; 805) des astigmatischen optischen Elements (7, 7'; 107; 207; 407; 607; 707; 807) zusammenfällt.

8. Vorrichtung nach einem der vorhergehenden Ansprüche, **dadurch gekennzeichnet, daß** die abgegebene Strahlungsleistungen der Einzel-Lichtquellen (3, 3'; 103; 203; 303, 319; 403; 603; 703; 803; 903, 903') innerhalb einer Einzel-Lichtquellengruppe (4, 4'; 204; 304; 404; 604; 704; 804) und/oder die zu verschiedenen Einzel-Lichtquellengruppen (4, 4') gehörenden Einzel-Lichtquellen (3, 3'; 903, 903') jeweils gemeinsam und/oder verschiedene Lichtquellen (1004, 1082) von einer Leistungsregelungseinrichtung (979) individuell steuerbar sind.

9. Vorrichtung nach einem der vorhergehenden Ansprüche, **dadurch gekennzeichnet, daß** mindestens zwei Einzel-Lichtquellen (3, 3'; 303, 319; 903, 903'; 1004, 1082) unterschiedliche Emissionswellenlängen haben.

10. Vorrichtung nach einem der vorhergehenden Ansprüche, **dadurch gekennzeichnet, daß** eine abbildende Oberfläche (9; 9'; 109; 209; 409; 609; 709; 809) des astigmatischen optischen Elements (7, 7'; 107; 207; 407; 607; 707; 807) eine von außen gesehen konkave Ringfläche ist.

11. Vorrichtung nach einem der Ansprüche 1 bis 9, **dadurch gekennzeichnet, daß** die abbildende Oberfläche (209) des astigmatischen optischen Elements (207) durch Facetten gebildet ist, die in einer mehrzähligen Symmetrie koaxial zur optischen Achse (205) an diesem angebracht sind.

12. Vorrichtung nach einem der vorhergehenden Ansprüche, **dadurch gekennzeichnet, daß** durch die zu überlagernden Emissionsbündel (402) der Einzel-Lichtquellen (403) der Einzel-Lichtquellengruppe (404) ein mittlerer, von Emissionsbündeln freier Raum begrenzt wird, in dem ein Reflektor (422) angeordnet ist, der Strahlung in sich zurückreflektiert, die von einem in der Arbeitsebene (413) liegenden Bearbeitungsbereich (423) eines Werkstücks (401) reflektiert oder reemittiert wird.

13. Vorrichtung nach Anspruch 12, **dadurch gekennzeichnet, daß** mindestens eine der bündelführenden optischen Komponenten (407, 411, 412) (7, 7', 11; 107; 207, 211; 407, 411, 412; 607, 611, 612; 707, 711, 712; 807, 811, 812) eine zentrale Öffnung (408, 414, 421) aufweist.

14. Vorrichtung nach Anspruch 13, **dadurch gekennzeichnet, daß** der Reflektor (422) in der Öffnung (421) angeordnet ist.

15. Vorrichtung nach einem der vorhergehenden Ansprüche, **dadurch gekennzeichnet, daß** die bündelführenden optischen Komponenten (7, 11, 12, 7'; 107; 207, 211, 407, 411, 412; 607, 611, 612; 707, 711, 712; 807, 811, 812) derart angeordnet sind, daß die optische Anordnung im Bereich um ihre optische Achse (5; 205; 405; 505; 605; 705; 805) einen durchgängigen freien Raum aufweist, in dem keine Strahlung der Einzel-Lichtquellengruppe (4, 4'; 204; 304; 404; 604; 704; 804) geführt ist.

16. Vorrichtung nach einem der vorhergehenden Ansprüche, **gekennzeichnet durch** eine Sensoranordnung (553; 653; 953; 1053; 1153) zur Erfassung des Bearbeitungsbereichs (623; 1023; 1123).

17. Vorrichtung nach Anspruch 16, **dadurch gekennzeichnet, daß** die Sensoranordnung (653) im freien Raum angeordnet ist.

18. Vorrichtung nach Anspruch 16 oder 17, **dadurch gekennzeichnet, daß** die Sensoranordnung (953) Teil der Leistungsregelungseinrichtung (979) ist.

19. Vorrichtung nach einem der Ansprüche 16 bis 18, **dadurch gekennzeichnet, daß** die Sensoranordnung (553; 653; 953; 1053; 1153) einen optischen Sensor (660; 1085, 1086; 1191) umfaßt.

20. Vorrichtung nach einem der Ansprüche 16 bis 19, **dadurch gekennzeichnet, daß** die Sensoranordnung (653; 1053) einen wellenlängenselektiven Filter (658; 1084) umfaßt.

21. Vorrichtung nach Anspruch 20, **dadurch gekennzeichnet, daß** mindestens zwei Einzel-Lichtquellen (603) unterschiedliche Emissionswellenlängen aufweisen und das wellenlängenselektive Filter (658; 1084) diese unterschiedlichen Emissionswellenlängen trennt.

22. Vorrichtung nach einem der Ansprüche 19 bis 21, **dadurch gekennzeichnet, daß** der Sensor (660; 1191) ein positionsempfindlicher optischer Sensor ist und die Sensoranordnung (653; 1153) zusätzlich eine Abbildungsoptik (659; 1190) zur Abbildung des Bearbeitungsbereichs (623; 1123) auf den Sensor (660; 1191) umfaßt.

23. Vorrichtung nach Anspruch 22, **dadurch gekennzeichnet, daß** der positionsempfindliche optische Sensor (660; 1191) ein Mehrdetektorensensor ist.

24. Vorrichtung nach Anspruch 23, **dadurch gekennzeichnet, daß** der positionsempfindliche Sensor (660; 1191) ein Quadrantendetektor ist.

25. Vorrichtung nach Anspruch 23, **dadurch gekennzeichnet, daß** der positionsempfindliche Sensor (660; 1191) ein CCD-Detektor ist.

26. Vorrichtung nach Anspruch 23, **dadurch gekennzeichnet, daß** der positionsempfindliche Sensor (660; 1191) eine CMOS-Kamera ist.

27. Vorrichtung nach einem der Ansprüche 16 bis 26,
**dadurch gekennzeichnet, daß** ein Schallwellensensor Teil der Sensoranordnung (1053) ist.

28. Vorrichtung nach einem der Ansprüche 16 bis 27, **dadurch gekennzeichnet, daß** die Sensoranordnung (1191) in Signalverbindung steht mit einer elektronischen Auswerteeinrichtung (1192) zur Bestimmung der Relativposition zwischen Arbeitsebene (1113) und Werkstück.

29. Vorrichtung nach einem der vorhergehenden Ansprüche, **gekennzeichnet durch** eine Ausgleichseinrichtung zur Kompensation mechanisch oder thermisch induzierter Deformationen von Einzel-Lichtquellen (403; 503) der Einzel-Lichtquellengruppe (404, 504) oder von bündelführenden Komponenten oder von Halte- bzw. Kühlkörpern (440; 540) von diesen mit Aktuatoren (435; 541, 550) zur gesteuerten Deformation oder zur Positionierung von Bereichen der Einzel-Lichtquellen (403; 503) der Einzel-Lichtquellengruppe (404; 504) oder von bündelführenden Komponenten oder von Halte- bzw. Kühlkörpern (440; 540) von diesen.

30. Vorrichtung nach Anspruch 29, **dadurch gekennzeichnet, daß** die Aktuatoren (541, 550) über eine Steuereinrichtung (552, 555) mit einer Detektionseinrichtung (553) in Signalverbindung stehen, die einen Sensor zur Erfassung der Deformationen aufweist.

31. Vorrichtung nach Anspruch 30 bei Rückbeziehung auf die Ansprüche 16 bis 29, **dadurch gekennzeichnet, daß** der Sensor der Sensoranordnung (653) als Sensor der Detektionseinrichtung (553) dient.

32. Vorrichtung nach Anspruch 31, **dadurch gekennzeichnet, daß** der Sensor der Detektionseinrichtung (553) ein Wegaufnehmer zur direkten Bestimmung der Deformationen ist.

33. Vorrichtung nach einem der Ansprüche 29 bis 32, **dadurch gekennzeichnet, daß** die Aktuatoren eine Mehrzahl von mit einem Fluidreservoir (548) über Fluidkanäle (545, 549, 551) verbundenen Druckkammern (541) aufweisen, wobei die Steuereinrichtung (552, 555) zur individuellen Steuerung des jeweiligen Fluiddrucks in der Druckkammer (541) dient.

34. Vorrichtung nach Anspruch 33, **dadurch gekennzeichnet, daß** jeder Druckkammer (541) ein geschlossener Fluidkreislauf (539) zugeordnet ist, der eine Zuflußleitung (545) von und eine Abflußleitung (549, 551) hin zu einem Fluidreservoir (548) umfaßt und in dem ein Steuerventil (550) angeordnet ist, das mit der Steuereinrichtung (552, 555) zusammenarbeitet.

35. Vorrichtung nach Anspruch 34, **dadurch gekennzeichnet, daß** der Fluidkreislauf (539) Teil einer Kühleinrichtung der optischen Anordnung ist.

36. Vorrichtung nach Anspruch 35, **dadurch gekennzeichnet, daß** die Kühleinrichtung Kühlkörper (540) aus gut wärmeleitendem Material aufweist, in denen das Kühlfluid zirkuliert und die an die Einzel-Lichtquelle (503) oder die bündelführenden Komponenten thermisch angekoppelt sind.

37. Vorrichtung nach Anspruch 36, **dadurch gekennzeichnet, daß** die Einzel-Lichtquellen (503) der Einzel-Lichtquellengruppe (504) oder die bündelführenden Komponenten über die Kühlkörper (540) an Halteeinrichtungen (524) aus einem Material mit geringem Wärmeausdehnungkoeffizienten angekoppelt sind.

38. Vorrichtung nach Anspruch 36 oder 37, **dadurch gekennzeichnet, daß** die Kühlkörper (540) und/oder die Halteeinrichtung (524) aus Keramik bestehen.

39. Vorrichtung nach einem der Ansprüche 33 bis 36, **gekennzeichnet durch** eine Überwachungseinrichtung (554) für Zustandsparameter des Druck- und/oder Kühlfluids.

40. Vorrichtung nach einem der Ansprüche 29 bis 32, **dadurch gekennzeichnet, daß** die Aktuatoren durch Piezoelemente (435) gebildet sind.

41. Vorrichtung nach einem der Ansprüche 17 bis 40, bei Rückbeziehung auf Anspruch 15, **dadurch gekennzeichnet, daß** in dem durchgängigen freien Raum eine optische Zusatz-Anordnung (763) zur Fokussierung eines Emissionsbündels (764) einer Zusatz-Lichtquelle, die nicht Teil einer Einzel-Lichtquellengruppe ist, angeordnet ist, wobei der Arbeitsfokus (769) der Zusatz-Lichtquelle in der Arbeitsebene (713) der Einzel-Lichtquellengruppe (704) liegt.

42. Vorrichtung nach Anspruch 41, **dadurch gekennzeichnet, daß** eine Stelloptik (763) zur Einstellung der Position und/oder der Größe des Arbeitsfokus (769) der Zusatz-Lichtquelle Teil der optischen Zusatz-Anordnung ist.

43. Vorrichtung nach Anspruch 42, **dadurch gekennzeichnet, daß** die Stelloptik (763) durch mindestens eine Linse (767, 768) oder ein Objektiv gebildet und in einem Gehäuse (766) angeordnet ist, das über eine Verstelleinrichtung relativ zur optischen Achse (705) und zum Bearbeitungsbereich (723) verstellt werden kann.

44. Vorrichtung nach Anspruch 43, **dadurch gekennzeichnet, daß** die mit der optischen Achse (770) der Stelloptik (763) zusammenfallende Längsachse des Gehäuses (766) zur optischen Achse (705) der Komponenten (707, 711, 712) der optischen Anordnung, die die Emissionsbündel (702) der Einzel-Lichtquellen (703) der Einzel-Lichtquellengruppe (704) führen, geneigt ist, wobei die Verstelleinrichtung einen Drehantrieb zum Verdrehen der Stelloptik (763) um die optische Achse (705) der Komponenten (707, 711, 712) der optischen Anordnung aufweist.

45. Vorrichtung nach einem der Ansprüche 43 oder 44, **dadurch gekennzeichnet, daß** die Verstelleinrichtung (1195) mit einer Positioniersteuerung (1192, 1193) zur Positionierung des Arbeitsfokus (1169) gegenüber dem Bearbeitungsbereich (1123) in Signalverbindung steht.

46. Vorrichtung nach Anspruch 45, **dadurch gekennzeichnet. daß** die Positioniersteuerung (1192, 1193) mit einer Überwachungseinrichtung (1191, 1194) zur Bestimmung von Lage- und/oder Bearbeitungsparametern des Werkstücks, in Signalverbindung steht.

47. Vorrichtung nach Anspruch 45 oder 46 bei Rückbeziehung auf Anspruch 8, **dadurch gekennzeichnet, daß** die Bearbeitungssteuerung (1192, 1193) mit der Leistungsregelungseinrichtung (1179) in Signalverbindung steht.

48. Vorrichtung nach einem der Ansprüche 41 bis 47, **dadurch gekennzeichnet, daß** die Zusatz-Lichtquelle ein Festkörperlaser ist.

49. Vorrichtung nach einem der Ansprüche 41 bis 48,
**dadurch gekennzeichnet, daß** die Zusatz-Lichtquelle zur Stelloptik (763) über ein Strahlführungssystem, vorzugsweise eine optische Faser (765), geführt ist, dessen Auskoppelende fest mit dem Gehäuse (766) der Stelloptik (763) verbunden ist.

50. Vorrichtung nach einem der vorhergehenden Ansprüche bei Rückbeziehung auf Anspruch 15, **dadurch gekennzeichnet, daß** in dem durchgängigen freien Raum zumindest teilweise eine Schweißanordnung zum Lichtbogenschweißen angeordnet ist, wobei ein Schweiß-Arbeitsbereich der Schweißanordnung in der Arbeitsebene der Einzel-Lichtquellengruppe liegt.

51. Vorrichtung nach einem der vorhergehenden Ansprüche bei Rückbeziehung auf Anspruch 15, **gekennzeichnet durch** eine Fluid-Fördervorrichtung (871), die mit einem Fluidreservoir verbunden ist und eine zumindest teilweise im durchgängigen Raum freier Apertur angeordnete Fördereinrichtung (872, 873) mit einem Förderende (874) für Fluid aufweist, mittels derer der Bearbeitungsbereich (823) mit Fluid beaufschlagbar ist und/oder Fluid aus dem Bearbeitungsbereich (823) absaugbar ist.

52. Vorrichtung nach Anspruch 51, **dadurch gekennzeichnet, daß** die Fördereinrichtung eine Förderröhre (873) umfaßt, in der das Fluid zumindest abschnittsweise innerhalb des durchgängigen freien Aperturbereichs geführt ist und deren Förderende (874) dem Bearbeitungsbereich (823) benachbart ist.

53. Vorrichtung nach Anspruch 51 oder 52, **dadurch gekennzeichnet, daß** das Förderende als Düse (874) ausgeführt ist.

54. Vorrichtung nach einem der Ansprüche 51 bis 53, **dadurch gekennzeichnet, daß** das Förderende (874) austauschbar ist.

55. Vorrichtung nach einem der Ansprüche 51 bis 54, **gekennzeichnet durch** eine Entfernungsmeßeinrichtung (875) zur Bestimmung der Entfernung des Förderendes (874) vom Werkstück (801).

56. Vorrichtung nach Anspruch 55, **dadurch gekennzeichnet, daß** zumindest das Förderende (874) aus elektrisch leitendem Material ist und eine Halterung aufweist, die das Förderende (874) elektrisch gegenüber dem Werkstück (801) isoliert, wobei die Entfernungsmeßeinrichtung (875) eine Kapazitätsmeßanordnung zur Bestimmung der Kapazität zwischen Förderende (874) und Werkstück (801) ist.

57. Vorrichtung nach Anspruch 56, **dadurch gekennzeichnet, daß** die Förderröhre (873) aus elektrisch leitfähigem Material ist und zumindest abschnittsweise von einer Abschirmelektrode (877) umgeben ist.

58. Vorrichtung nach einem der Ansprüche 51 bis 57, **gekennzeichnet durch** eine Einrichtung (876) zur Erzeugung einer axialen Relativbewegung zwischen Förderröhre (873) und Abschirmelektrode (877).

59. Vorrichtung nach Anspruch 57 oder 58, **dadurch gekennzeichnet, daß** die Abschirmelektrode (877) als zur Förderöhre (873) koaxiale Abschirmröhre ausgebildet ist.

60. Vorrichtung nach einem der Ansprüche 51 bis 59, **gekennzeichnet durch** eine Positioniereinrichtung (876) zur Erzeugung einer Relativbewegung zwischen Förderende (874) und Werkstück (801).

61. Vorrichtung nach Anspruch 60, **dadurch gekennzeichnet, daß** die Positioniereinrichtung (876) eine Justiereinrichtung (896) zur Feinpositionierung des Förderendes (874) gegenüber dem werkstück (801) umfaßt.

62. Vorrichtung nach Anspruch 61, **dadurch gekennzeichnet, daß** die Justiereinrichtung (896) eine an der Fördereinrichtung (872, 873) angebrachte Justier-Lichtquelle aufweist, deren Strahlung kollimiert zumindest durch das Förderende (874) der Fördereinrichtung (872, 873) geführt ist.

63. Vorrichtung nach Anspruch 62, **dadurch gekennzeichnet, daß** die Lichtquelle eine im sichtbaren wellenlängenbereich arbeitende Laserdiode (896) ist.

64. Vorrichtung nach einem der Ansprüche 61 bis 63, **dadurch gekennzeichnet, daß** das Fluid ein dem Bearbeitungsbereich (823) unter hohem Druck zugeführtes Gas ist.

65. Vorrichtung nach einem der vorhergehenden Ansprüche, **dadurch gekennzeichnet, daß** mehrere koaxial zur optischen Achse (5) angeordnete Einzel-Lichtquellengruppen (4, 4') vorgesehen sind.

## Claims

1. An apparatus having at least one light source which has or have a number of individual light sources (3, 3'; 103; 203; 303, 319; 403; 503; 603; 703; 803; 903; 903'), and having an optical arrangement, which, by superimposition, produces a working focused beam with a high power density from the emitted beams from the individual light sources (3, 3'; 103; 203; 303, 319; 403; 503; 603; 703; 803; 903, 903'), with
a) at least two individual light sources (3, 3'; 103; 203; 303, 319; 403; 503; 603; 703; 803; 903, 903') having an emission area with axes which are of different length and are perpendicular to each other;
b) at least two individual light sources (3, 3'; 103; 203; 303, 319; 403; 503; 603; 703; 803; 903, 903') forming at least one individual light source group (4, 4'; 204; 304; 404; 604; 704; 804) which is arranged coaxially with respect to the optical axis (5; 205; 405; 505; 605; 705; 805) of an astigmatic optical element (7, 7'; 107; 207; 407; 607; 707; 807) to which the emitted beams from the individual light sources (3, 3'; 103; 203; 403; 603; 703; 803; 903, 903') are applied;
c) in each case one axis of the emission area (306, 306') of an individual light source (3, 3'; 103; 203; 403; 603; 703; 803; 903, 903') being located on a meridional plane, which is defined by the center point of the emission area (306, 306') of the astigmatic optical element (7, 7'; 107; 207; 407; 607; 707; 807), and the other axis of the emission area (306, 306') being located on the corresponding sagittal plane of the astigmatic optical element (7, 7'; 107; 207; 407; 607; 707; 807);
d) the astigmatic optical element (7, 7'; 107; 207; 407; 607; 707; 807) having different imaging characteristics in the meridional and sagittal planes which are associated with the emission areas (306, 306') of the respective individual light sources (3, 3'; 103; 203; 403; 603; 703; 803; 903, 903'), such that each emitted beam (2; 102; 202; 402; 502; 602; 702; 802) from the individual light sources (3, 3'; 103; 203; 403; 603; 703; 803; 903, 903') has a cross-sectional area with axes of essentially the same length in the beam path downstream from the astigmatic optical element (7, 7'; 107; 207; 407; 607; 707; 807) in at least one compensating plane (13; 413; 613; 713; 813; 1013; 1113) which is at right angles to the optical axis (5; 205; 405; 505; 605; 705; 805) of the astigmatic optical element (7, 7'; 107; 207; 407; 607; 707; 807); and
e) all the emitted beams (2; 102; 202; 402; 502; 602; 702; 802) being guided by beam-guiding components (7, 11, 12, 7'; 107; 207, 211; 407, 411, 412; 607, 611, 612; 707, 711, 712; 807, 811, 812) in a working plane (13; 314; 613; 713; 813; 1013; 1113) which is formed either by the compensating plane or by an imaging plane which is common to all the focused beams.

2. The apparatus as claimed in claim 1, **characterized in that** the individual light source group (4, 4'; 204; 304; 404; 604; 704; 804) has individual light sources (3, 3'; 103; 203; 303, 319; 403; 603; 703; 803; 903, 903') which have a number of individual emitters which are arranged, in particular, in a row alongside one another and emit individual light bundles.

3. The apparatus as claimed in claim 1 or 2,
**characterized in that** at least one individual light source (3, 3'; 103; 203; 303, 319; 403; 503; 603; 703; 803; 903, 903') is a laser.

4. The apparatus as claimed in claim 3, **characterized in that** at least some of the individual emitters are laser diodes.

5. The apparatus as claimed in one of claims 2 to 4, **characterized in that** at least one individual emitter is formed by the output fiber ends of a fiber bundle (315) with a rectangular emission area (306'), which is optically coupled to an emitted beam (318) from a light source (319).

6. The apparatus as claimed in one of claims 2 to 5, **characterized in that** at least one laser is a solid-state laser (319; 1082).

7. The apparatus as claimed in one of the preceding claims, **characterized in that** the emission areas (306, 306') of the individual light sources (3, 3'; 103; 203; 303, 319; 403; 603; 703; 803; 903, 903') form a polygon, whose center axis coincides with the optical axis (5; 205; 405; 505; 605; 705; 805) of the astigmatic optical element (7, 7'; 107; 207; 407; 607; 707; 807).

8. The apparatus as claimed in one of the preceding claims, **characterized in that** the emitted beam powers from the individual light sources (3, 3'; 103; 203; 303, 319; 403; 603; 703; 803; 903, 903') within an individual light source group (4, 4'; 204; 304; 404; 604; 704; 804) and/or the individual light sources (3, 3'; 903, 903') which are associated with different individual light source groups (4, 4'), can in each case be controlled jointly, and/or different light sources (1004, 1082) can be controlled individually, by a power control device (979).

9. The apparatus as claimed in one of the preceding claims, **characterized in that** at least two individual light sources (3, 3'; 303, 319; 903, 903'; 1004, 1082) have different emission wavelengths.

10. The apparatus as claimed in one of the preceding claims, **characterized in that** an imaging surface (9; 9'; 109; 209; 409; 609; 709; 809) of the astigmatic optical element (7, 7'; 107; 207; 407; 607; 707; 807) is an annular surface which is concave when seen from the outside.

11. The apparatus as claimed in one of claims 1 to 9, **characterized in that** the imaging surface (209) of the astigmatic optical element (207) is formed by facets which are fitted to it with multiple symmetry, coaxially with respect to the optical axis (205).

12. The apparatus as claimed in one of the preceding claims, **characterized in that** a central space, which is free of emitted beams, is bounded by the emitted beams (402), which are to be superimposed, from the individual light sources (403) in the individual light source group (404), in which space a reflector (422) is placed, which intrinsically reflects back radiation which is reflected or re-emitted from a processing region (423), which is located in the working plane (413) of a workpiece (401).

13. The apparatus as claimed in claim 12,
**characterized in that** at least one of the beam-guiding optical components (407, 411, 412) (7, 7', 11; 107; 207, 211; 407, 411, 412; 607, 611, 612; 707, 711, 712; 807, 811, 812) has a central opening (408, 414, 421).

14. The apparatus as claimed in claim 13,
**characterized in that** the reflector (422) is placed in the opening (421).

15. The apparatus as claimed in one of the preceding claims, **characterized in that** the beam-guiding optical components (7, 11, 12, 7'; 107; 207, 211, 407, 411, 412; 607, 611, 612; 707, 711, 712; 807, 811, 812) are arranged such that the optical arrangement in the region about their optical axis (5; 205; 405; 505; 605; 705; 805) has a continuous free space, in which no radiation from the individual light source group (4, 4'; 204; 304; 404; 604; 704; 804) is carried.

16. The apparatus as claimed in one of the preceding claims, **characterized by** a sensor arrangement (553; 653; 953; 1053; 1153) for monitoring the processing region (623; 1023; 1123).

17. The apparatus as claimed in claim 16,
**characterized in that** the monitoring device (653) is placed in the free space.

18. The apparatus as claimed in claim 16 or 17, **characterized in that** the monitoring device (953) is part of the power control device (979).

19. The apparatus as claimed in one of claims 16 to 18, **characterized in that** the monitoring device (553; 653; 953; 1053; 1153) has an optical sensor (660; 1085, 1086; 1191).

20. The apparatus as claimed in one of claims 16 to 19, **characterized in that** the monitoring device (653; 1053) has a wavelength dependent filter (658; 1084).

21. The apparatus as claimed in claim 20, **characterized in that** at least two individual light sources (603) have different emission wavelengths, and the wavelength dependent filter (658; 1084) separates these different emission wavelengths.

22. The apparatus as claimed in one of claims 19 to 21, **characterized in that** the sensor (660; 1191) is a position-sensitive optical sensor, and the monitoring device (653; 1153) also has imaging optics (659; 1190) for imaging the processing region (623; 1123) onto the sensor (660; 1191).

23. The apparatus as claimed in claim 22, **characterized in that** the position-sensitive optical sensor (660; 1191) is a multiple detector sensor.

24. The apparatus as claimed in claim 23, **characterized in that** the position-sensitive sensor (660; 1191) is a four-quadrant detector.

25. The apparatus as claimed in claim 23, **characterized in that** the position-sensitive sensor (660; 1191) is a CCD detector.

26. The apparatus as claimed in claim 23, **characterized in that** the position-sensitive sensor (660; 1191) is a CMOS camera.

27. The apparatus as claimed in one of claims 16 to 26, **characterized in that** an acoustic sensor is part of the sensor arrangement (1053).

28. The apparatus as claimed in one of claims 16 to 27, **characterized in that** the sensor arrangement (1191) is inter-connected with an electronic processing device (1192) for determining the relative position between the working plane (1113) and the workpiece.

29. The apparatus as claimed in one of the preceding claims, **characterized by** a compensating device for compensating for mechanically or thermally induced deformation of individual light sources (403; 503) in the individual light source group (404; 504) or of beam-guiding components or of holding bodies or heat sinks (440; 540) of them with actuators (435; 541, 550) for controlled deformation or for positioning of regions of the individual light sources (403; 503) in the individual light source group (404; 504) or of beam-guiding components, or of holding bodies or heat sinks (440; 540) of them.

30. The apparatus as claimed in claim 29, **characterized in that** the actuators (541, 550) are inter-connected with a control unit (552, 555) which is processing the signals from a detection device (553) which includes a deformation monitoring sensor.

31. The apparatus as claimed in claim 30 and referring back to claims 16 to 29, **characterized in that** the sensor of the monitoring device (653) is used as a sensor of the detection device (553).

32. The apparatus as claimed in claim 31, **characterized in that** the sensor of the detection device (553) is a position sensor for direct determination of the deformation.

33. The apparatus as claimed in one of claims 29 to 32, **characterized in that** the actuators have a number of pressure chambers (541) which are connected to a fluid reservoir (548) via fluid channels (545, 549, 551), with the control device (552, 555) being used for individual control of the respective fluid pressure in the pressure chamber (541).

34. The apparatus as claimed in claim 33, **characterized in that** each pressure chamber (541) has an associated closed fluid circuit (539), which has an inlet flow line (545) from and an outlet flow line (549, 551) to a fluid reservoir (548) and in which a control valve (550) is arranged, which interacts with the control device (552, 555).

35. The apparatus as claimed in claim 34, **characterized in that** the fluid circuit (539) is part of a cooling device for the optical arrangement.

36. The apparatus as claimed in claim 35, **characterized in that** the cooling device has heat sinks (540) composed of highly thermally conductive material, in which the cooling fluid circulates and which are thermally coupled to the individual light source (503) or to the beam-guiding components.

37. The apparatus as claimed in claim 36, **characterized in that** the individual light sources (503) in the individual light source group (504) or the beam-guiding components are coupled via the heat sinks (540) to holding devices (524) composed of a material having a low thermal coefficient of expansion.

38. The apparatus as claimed in claim 36 or 37, **characterized in that** the heat sinks (540) and/or the holding device (524) are composed of ceramic.

39. The apparatus as claimed in one of claims 33 to 36, **characterized by** a monitoring device (554) for state parameters of the pressure and/or cooling fluid.

40. The apparatus as claimed in one of claims 29 to 32, **characterized in that** the actuators are formed by piezoelectric elements (435).

41. The apparatus as claimed in one of claims 17 to 40 and referring back to claim 15, **characterized in that** an additional optical arrangement (763) is placed in the continuous free space for focusing of an emitted beam (764) from an additional light source which is not part of an individual light source group, with the working focus (769) of the additional light source being located on the working plane (713) of the individual light source group (704).

42. The apparatus as claimed in claim 41, **characterized in that** adjustment optics (763) for adjusting the position and/or the size of the working focus (769) of the additional light source are part of the additional optical arrangement.

43. The apparatus as claimed in claim 42, **characterized in that** the adjustment optics (763) are formed by at least one lens (767, 768) or one objective and are arranged in a housing (766) which can be adjusted via an adjustment device relative to the optical axis (705) and relative to the processing region (723).

44. The apparatus as claimed in claim 43, **characterized in that** the longitudinal axis of the housing (766), which coincides with the optical axis (770) of the adjustment optics (763), is inclined with respect to the optical axis (705) of those components (707, 711, 712) of the optical arrangement which carry the emitted beams (702) from the individual light sources (703) in the individual light source group (704), with the adjustment device having a rotary drive for rotating the adjustment optics (763) about the optical axis (705) of the components (707, 711, 712) of the optical arrangement.

45. The apparatus as claimed in one of claims 43 or 44, **characterized in that** the adjustment device (1195) is inter-connected with a positioning controller (1192, 1193) for positioning the working focus (1169) with respect to the processing region (1123).

46. The apparatus as claimed in claim 45, **characterized in that** the positioning controller (1192, 1193) is inter-connected with a monitoring device (1191, 1194) for determining position and/or processing parameters of the workpiece.

47. The apparatus as claimed in claim 45 or 46 and referring back to claim 8, **characterized in that** the processing controller (1192, 1193) is inter-connected with the power control device (1179).

48. The apparatus as claimed in one of claims 41, to 47, **characterized in that** the additional light source is a solid state laser.

49. The apparatus as claimed in one of claims 41 to 48, **characterized in that** the additional light source is guided with respect to the adjustment optics (763) over a beam delivery system, preferably an optical fiber (765), whose output end is firmly connected to the housing (766) of the adjustment optics (763).

50. The apparatus as claimed in one of the preceding claims and referring back to claim 15, **characterized in that** an apparatus for arc welding is at least partially located in the continuous free space, having the Tool-Center-Point of the arc welding apparatus positioned in the same working plane of the individual light source group.

51. The apparatus as claimed in one of the preceding claims and referring back to claim 15, **characterized by** a fluid feed apparatus (871) which is connected to a fluid reservoir and has a feed device (872, 873) which is at least partially arranged in the free space, with a free aperture, and has a feed end (874) for fluid, by means of which fluid can be applied to the processing region (823) and/or fluid can be sucked out of the processing region (823).

52. The apparatus as claimed in claim 51, **characterized in that** the feed device has a feed tube (873) in which the fluid is guided at least in places within the continuous free aperture region, and whose feed end (874) is adjacent to the processing region (823).

53. The apparatus as claimed in claim 51 or 52, **characterized in that** the feed end is in the form of a nozzle (874).

54. The apparatus as claimed in one of claims 51 to 53, **characterized in that** the feed end (874) is interchangeable or replaceable.

55. The apparatus as claimed in one of claims 51 to 54, **characterized by** a distance measurement device (875) for determining the distance between the feed end (874) and the workpiece (801).

56. The apparatus as claimed in claim 55, **characterized in that** at least the feed end (874) is composed of electrically conductive material and has a holder which electrically isolates the feed end (874) from the workpiece (801), with the distance measurement device (875) being a capacitance measurement arrangement for determining the capacitance between the feed end (874) and the workpiece (801).

57. The apparatus as claimed in claim 56, **characterized in that** the feed tube (873) is composed of electrically conductive material and is surrounded, at least in partially, by a shielding electrode (877).

58. The apparatus as claimed in one of claims 51 to 57, **characterized by** a device (876) for producing an axial relative movement between the feed tube (873) and the shielding electrode (877).

59. The apparatus as claimed in claim 57 or 58, **characterized in that** the shielding electrode (877) is in the form of a shielding tube which is coaxial with respect to the feed tube (873).

60. The apparatus as claimed in one of claims 51 to 59, **characterized by** a positioning device (876) for generating a relative movement between the feed end (874) and the workpiece (801).

61. The apparatus as claimed in claim 60, **characterized in that** the positioning device (876) has an adjusting device (896) for fine positioning of the feed end (874) with respect to the workpiece (801).

62. The apparatus as claimed in claim 61, **characterized in that** the adjusting device (896) has an adjusting light source which is fitted to the feed device (872, 873) and whose radiation is guided such that it is collimated at least by the feed end (874) of the feed device (872, 873).

63. The apparatus as claimed in claim 62, **characterized in that** the light source is a laser diode (896) which operates in the visible wavelength band.

64. The apparatus as claimed in one of claims 61 to 63, **characterized in that** the fluid is a gas which is supplied to the processing region (823) at high pressure.

65. The apparatus as claimed in one of the preceding claims, **characterized in that** a number of individual light source groups (4, 4') are provided, and are arranged coaxially with respect to the optical axis (5).

## Revendications

1. Dispositif comprenant au moins une source lumineuse formée de plusieurs sources lumineuses individuelles (3, 3' ; 103 ; 203 ; 303, 319 ; 403 ; 503 ; 603 ; 703 ; 803 ; 903, 903') et un dispositif optique qui génère par superposition des faisceaux d'émission des sources lumineuses individuelles (3, 3' ; 103 ; 203 ; 303, 319 ; 403 ; 503 ; 603 ; 703 ; 803 ; 903, 903') un faisceau de rayons de travail de puissance surfacique élevée, dams lequel
a) au moins deux sources lumineuses individuelles (3, 3' ; 103 ; 203 ; 303, 319 ; 403 ; 503 ; 603 ; 703 ; 803 ; 903, 903') présentent une surface d'émission ayant des axes de longueurs différentes, perpendiculaires entre eux ;
b) au moins deux sources lumineuses individuelles (3, 3' ; 103 ; 203 ; 303, 319 ; 403 ; 503 ; 603 ; 703 ; 803 ; 903, 903') forment au moins un groupe de sources lumineuses individuelles (4, 4' ; 204 ; 304 ; 404 ; 604 ; 704 ; 804) coaxial à l'axe optique (5 ; 205 ; 405 ; 505 ; 605 ; 705 ; 805) d'un élément optique astigmatique (7, 7' ; 107; 207 ; 407 ; 607 ; 707 ; 807) qui est exposé aux faisceaux d'émission des sources lumineuses individuelles (3, 3' ; 103 ; 203 ; 403 ; 603 ; 703 ; 803 ; 903, 903') ;
c) un axe de la surface d'émission (306, 306') d'une source lumineuse individuelle (3, 3' ; 103 ; 203 ; 403 ; 603 ; 703 ; 803 ; 903, 903') se trouve dans le plan méridien de l'élément optique astigmatique (7, 7' ; 107 ; 207 ; 407 ; 607 ; 707 ; 807) défini par le centre de la surface d'émission (306, 306') et l'autre axe de la surface d'émissiom (306, 306') se trouve dans le plan sagittal correspondant de l'élément optique astigmatique (7, 7' ; 107 ; 207 ; 407 ; 607 ; 707 ; 807) ;
d) l'élément optique astigmatique (7, 7' ; 107 ; 207 ; 407 ; 607 ; 707 ; 807) a dans les plans méridien et sagittal associés aux surfaces d'émission (306, 306') des sources lumineuses individuelles (3, 3' ; 103 ; 203 ; 403 ; 603 ; 703 ; 803 ; 903, 903') respectives des propriétés de formation d'image différentes, de telle sorte que chaque faisceau d'émission (2 ; 102 ; 202; 402; 502; 602; 702 ; 802) des sources lumineuses individuelles (3, 3' ; 103 ; 203 ; 403 ; 603 ; 703 ; 803 ; 903, 903') présente dans le trajet des rayons après l'élément optique astigmatique (7, 7' ; 107 ; 207 ; 407 ; 607 ; 707 ; 807), dans au moins un plan de compensation perpendiculaire à l'axe optique (5 ; 205 ; 405 ; 505 ; 605 ; 705 ; 805) de l'élément optique astigmatique (7, 7' ; 107 ; 207 ; 407 ; 607 ; 707 ; 807), une surface de section ayant des axes essentiellement de même longueur ; et
e) tous les faisceaux d'émission (2 ; 102 ; 202 ; 402 ; 502 ; 602 ; 702 ; 802) sont guidés par des composants guidant les faisceaux (7, 11, 12, 7' ; 107 ; 207, 211 ; 407, 411, 412 ; 607, 611, 612 ; 707, 711, 712 ; 807, 811, 812) vers un plan de travail (13 ; 314 ; 613 ; 713 ; 813 ; 1013 ; 1113) qui est formé soit par le plan de compensation, soit par un plan focal commun à tous les faisceaux de rayons.

2. Dispositif selon la revendication 1, **caractérisé par le fait que** le groupe de sources lumineuses individuelles (4, 4' ; 204 ; 304 ; 404 ; 604 ; 704 ; 804) comprend des sources lumineuses individuelles (3, 3' ; 103 ; 203 ; 303, 319 ; 403 ; 603 ; 703 ; 803 ; 903, 903') qui présentent une pluralité d'émetteurs individuels disposés côte à côte, en particulier sur un rang, qui émettent des faisceaux d'émission individuels.

3. Dispositif selon la revendication 1 ou 2, **caractérisé par le fait qu'**au moins une source lumineuse individuelle (3, 3' ; 103 ; 203 ; 303, 319 ; 403 ; 603 ; 703 ; 803 ; 903, 903') est un laser.

4. Dispositif selon la revendication 3, **caractérisé par le fait qu'**au moins une partie des émetteurs individuels est formée de diodes laser.

5. Dispositif selon l'une des revendications 2 à 4, **caractérisé par le fait qu'**au moins un émetteur individuel est formé par les extrémités de fibres de sortie d'un faisceau de fibres (315) à surface d'émission rectangulaire (306'), lequel est couplé optiquement à un faisceau d'émission (318) d'une source lumineuse (319).

6. Dispositif selon l'une des revendications 2 à 5, **caractérisé par le fait qu'**au moins un laser est un laser à solide (319 ; 1082).

7. Dispositif selon l'une des revendications précédentes, **caractérisé par le fait que** les surfaces d'émission (306, 306') des sources lumineuses individuelles (3, 3' ; 103 ; 203 ; 303, 319 ; 403 ; 603 ; 703 ; 803 ; 903, 903') forment un polygone dont l'axe central coïncide avec l'axe optique (5 ; 205 ; 405 ; 505 ; 605 ; 705 ; 805) de l'élément optique astigmatique (7, 7' ; 107 ; 207 ; 407 ; 607 ; 707 ; 807).

8. Dispositif selon l'une des revendications précédentes, **caractérisé par le fait que** les puissances de rayonnement émises par les sources lumineuses individuelles (3, 3' ; 103 ; 203 ; 303, 319; 403 ; 603 ; 703 ; 803 ; 903, 903') au sein d'un groupe de sources lumineuses individuelles (4, 4' ; 204 ; 304 ; 404 ; 604 ; 704 ; 804) et/ou les sources lumineuses individuelles (3, 3' ; 903, 903') appartenant à différents groupes de sources lumineuses individuelles (4, 4') peuvent être commandées en commun et/ou différentes sources lumineuses (1004, 1082) individuellement par un dispositif de réglage de puissance (979).

9. Dispositif selon l'une des revendications précédentes, **caractérisé par le fait qu'**au moins deux sources lumineuses individuelles (3, 3' ; 303, 319 ; 903, 903' ; 1004, 1082) ont des longueurs d'onde d'émission différentes.

10. Dispositif selon l'une des revendications précédentes, **caractérisé par le fait qu'**une surface de formation d'image (9, 9' ; 109 ; 209 ; 409 ; 609 ; 709 ; 809) de l'élément optique astigmatique (7, 7' ; 107 ; 207 ; 407 ; 607 ; 707 ; 807) est, vu de l'extérieur, une surface annulaire concave.

11. Dispositif selon l'une des revendications 1 à 9, **caractérisé par le fait que** la surface de formation d'image (209) de l'élément optique astigmatique (207) est formée de facettes qui sont disposées sur celui-ci de manière coaxiale à l'axe optique (205) avec une symétrie plurielle.

12. Dispositif selon l'une des revendications précédentes, **caractérisé par le fait que** les faisceaux d'émission (402) à superposer des sources lumineuses individuelles (403) du groupe de sources lumineuses individuelles (404) délimitent un espace central, libre de faisceaux d'émission, dans lequel on dispose un réflecteur (422) qui renvoie le rayonnement qui est réfléchi ou réémis par une zone d'usinage (423) d'une pièce (401) située dans le plan de travail (413).

13. Dispositif selon la revendication 12, **caractérisé par le fait qu'**au moins un des composants optiques guidant les faisceaux (407, 411, 412) (7, 7', 11 ; 107 ; 207, 211 ; 407, 411, 412 ; 607, 611, 612 ; 707, 711, 712 ; 807, 811, 812) présente une ouverture centrale (408, 414, 421).

14. Dispositif selon la revendication 13, **caractérisé par le fait que** le réflecteur (422) est disposé dans l'ouverture (421).

15. Dispositif selon l'une des revendications précédentes, **caractérisé par le fait que** les composants optiques guidant les faisceaux (7, 11, 12, 7' ; 107 ; 207, 211 ; 407, 411, 412 ; 607, 611, 612 ; 707, 711, 712 ; 807, 811, 812) sont disposés de telle sorte que l'arrangement optique présente dans la zone autour de son axe optique (5 ; 205 ; 405 ; 505 ; 605 ; 705 ; 805) un espace libre continu vers lequel aucun rayonnement du groupe de sources lumineuses individuelles (4, 4' ; 204 ; 304 ; 404 ; 604 ; 704 ; 804) n'est guidé.

16. Dispositif selon l'une des revendications précédentes, **caractérisé par** un dispositif capteur (553 ; 653 ; 953 ; 1053 ; 1153) pour la détection de la zone d'usinage (623 ; 1023 ; 1123).

17. Dispositif selon la revendication 16, **caractérisé par le fait que** le dispositif capteur (653) est placé dans l'espace libre.

18. Dispositif selon la revendication 16 ou 17, **caractérisé par le fait que** le dispositif capteur (653) fait partie du dispositif de réglage de puissance (979).

19. Dispositif selon l'une des revendications 16 à 18, **caractérisé par le fait que** le dispositif capteur (553 ; 653 ; 953 ; 1053 ; 1153) comprend un capteur optique (660 ; 1085, 1086 ; 1191).

20. Dispositif selon l'une des revendications 16 à 19, **caractérisé par le fait que** le dispositif capteur (653 ; 1053) comprend un filtre sélectif en longueur d'onde (658 ; 1084).

21. Dispositif selon la revendication 20, **caractérisé par le fait qu'**au moins deux sources lumineuses individuelles (603) présentent des longueurs d'onde d'émission différentes et que le filtre sélectif en longueur d'onde (658 ; 1084) sépare ces longueurs d'onde d'émission différentes.

22. Dispositif selon l'une des revendications 19 à 21, **caractérisé par le fait que** le capteur (660 ; 1191) est un capteur optique sensible à la position et que le dispositif capteur (653 ; 1153) comprend en outre une optique de formation d'image (659 ; 1190) pour former l'image de la zone d'usinage (623 ; 1123) sur le capteur (660 ; 1191).

23. Dispositif selon la revendication 22, **caractérisé par le fait que** le capteur optique sensible à la position (660 ; 1191) est un capteur à détecteurs multiples.

24. Dispositif selon la revendication 23, **caractérisé par le fait que** le capteur sensible à la position (660 ; 1191) est un détecteur à quadrants.

25. Dispositif selon la revendication 23, **caractérisé par le fait que** le capteur sensible à la position (660 ; 1191) est un détecteur CCD.

26. Dispositif selon la revendication 23, **caractérisé par le fait que** le capteur sensible à la position (660 ; 1191) est une caméra CMOS.

27. Dispositif selon l'une des revendications 16 à 26, **caractérisé par le fait qu'**un capteur d'ondes sonores fait partie du dispositif capteur (1053).

28. Dispositif selon l'une des revendications 16 à 27, **caractérisé par le fait que** le dispositif capteur (1191) est en liaison par signaux avec un dispositif électronique d'évaluation (1192) pour la détermination de la position relative entre le plan de travail (1113) et la pièce à usiner.

29. Dispositif selon l'une des revendications précédentes, **caractérisé par** un dispositif de compensation pour la compensation des déformations d'origine mécanique ou thermique de sources lumineuses individuelles (403 ; 503) du groupe de sources lumineuses individuelles (404 ; 504) ou de composants guidant les faisceaux ou de supports et/ou de refroidisseurs (440 ; 540) de ceux-ci au moyen d'actionneurs (435 ; 541 ; 550) pour la déformation contrôlée ou pour le positionnement de zones des sources lumineuses individuelles (403 ; 503) du groupe de sources lumineuses individuelles (404 ; 504) ou de composants guidant les faisceaux ou de supports et/ou de refroidisseurs (440 ; 540) de ceux-ci.

30. Dispositif selon la revendication 29, **caractérisé par le fait que** les actionneurs (541 ; 550) sont en liaison par signaux via un dispositif de commande (552, 555) avec un dispositif de détection (553) qui présente un capteur pour la détection des déformations.

31. Dispositif selon la revendication 30, avec référence aux revendications 16 à 29, **caractérisé par le fait que** le capteur du dispositif capteur (653) sert de capteur du dispositif de détection (553).

32. Dispositif selon la revendication 31, **caractérisé par le fait que** le capteur du dispositif de détection (553) est un capteur de déplacement pour la détermination directe des déformations.

33. Dispositif selon l'une des revendications 29 à 32, **caractérisé par le fait que** les actionneurs présentent une pluralité de chambres de pression (541) en communication avec un réservoir de fluide (548) par des canaux de fluide (545, 549, 551), le dispositif de commande (552, 555) servant à la commande individuelle de la pression de fluide respective dans la chambre de pression (541).

34. Dispositif selon la revendication 33, **caractérisé par le fait qu'**à chaque chambre de pression (541) est associé un circuit fermé de fluide (539) qui comprend une conduite d'alimentation (545) venant d'un réservoir de fluide (548) et une conduite de décharge (549, 551) allant à celui-ci et dans lequel se trouve une vanne de commande (550) qui coopère avec le dispositif de commande (552, 555).

35. Dispositif selon la revendication 34, **caractérisé par le fait que** le circuit de fluide (539) fait partie d'un dispositif de refroidissement de l'arrangement optique.

36. Dispositif selon la revendication 35, **caractérisé par le fait que** le dispositif de refroidissement présente des refroidisseurs (540) en matériau bon conducteur de la chaleur dans lesquels le fluide de refroidissement circule et qui sont couplés thermiquement à la source lumineuse individuelle (503) ou aux composants guidant les faisceaux.

37. Dispositif selon la revendication 36, **caractérisé par le fait que** les sources lumineuses individuelles (503) du groupe de sources lumineuses individuelles (504) ou les composants guidant les faisceaux sont couplés par l'intermédiaire des refroidisseurs (540) à des dispositifs de support (524) en matériau à faible coefficient de dilatation thermique.

38. Dispositif selon la revendication 36 ou 37, **caractérisé par le fait que** les refroidisseurs (540) et/ou les dispositifs de support (524) sont en céramique.

39. Dispositif selon l'une des revendications 33 à 36, **caractérisé par** un dispositif de surveillance (554) des paramètres d'état du fluide de pression et/ou de refroidissement.

40. Dispositif selon l'une des revendications 29 à 32, **caractérisé par le fait que** les actionneurs sont formés par des éléments piézoélectriques (435).

41. Dispositif selon l'une des revendications 17 à 40, avec référence à la revendication 15, **caractérisé par le fait qu'**un arrangement optique supplémentaire (763) pour la focalisation d'un faisceau d'émission (764) d'une source lumineuse supplémentaire, qui ne fait pas partie d'un groupe de sources lumineuses individuelles, est disposé dans l'espace libre continu, le foyer de travail (769) de la source lumineuse supplémentaire étant situé dans le plan de travail (713) du groupe de sources lumineuses individuelles (704).

42. Dispositif selon la revendication 41, **caractérisé par le fait qu'**une optique de réglage (763) pour le réglage de la position et/ou de la taille du foyer de travail (769) de la source lumineuse supplémentaire fait partie de l'arrangement optique supplémentaire.

43. Dispositif selon la revendication 42, **caractérisé par le fait que** l'optique de réglage (763) est formée par au moins une lentille (767, 768) ou un objectif et disposée dans un boîtier (766) qui peut être déplacé par rapport à l'axe optique (705) et la zone d'usinage (723) au moyen d'un dispositif de déplacement.

44. Dispositif selon la revendication 43, **caractérisé par le fait que** l'axe longitudinal du boîtier (766) coïncidant avec l'axe optique (770) de l'optique de réglage (763) est incliné par rapport à l'axe optique (705) des composants (707, 711, 712) de l'arrangement optique qui guident les faisceaux d'émission (702) des sources lumineuses individuelles (703), le dispositif de déplacement présentant un servomoteur pour tourner l'optique de réglage (763) autour de l'axe optique (705) des composants (707, 711, 712) de l'arrangement optique.

45. Dispositif selon l'une des revendications 43 ou 44, **caractérisé par le fait que** le dispositif de déplacement (1195) est en liaison par signaux avec une commande de positionnement (1192, 1193) pour le positionnement du foyer de travail (1169) par rapport à la zone d'usinage (1123).

46. Dispositif selon la revendication 45, **caractérisé par le fait que** la commande de positionnement (1192, 1193) est en liaison par signaux avec un dispositif de surveillance (1191, 1194) pour la détermination de paramètres de position et/ou d'usinage de la pièce à usiner.

47. Dispositif selon la revendication 45 ou 46, avec référence à la revendication 8, **caractérisé par le fait que** la commande d'usinage (1192, 1193) est en liaison par signaux avec le dispositif de réglage de puissance (1179).

48. Dispositif selon l'une des revendications 41 à 47, **caractérisé par le fait que** la source lumineuse supplémentaire est un laser à solide.

49. Dispositif selon l'une des revendications 41 à 48, **caractérisé par le fait que** la source lumineuse supplémentaire est guidée vers l'optique de réglage (763) par un système de guidage de faisceau, de préférence une fibre optique (765), dont l'extrémité de sortie est liée de manière fixe au boîtier (766) de l'optique de réglage (763).

50. Dispositif selon l'une des revendications précédentes, avec référence à la revendication 15, **caractérisé par le fait qu'**un dispositif de soudage permettant le soudage à l'arc est disposé, au moins partiellement, dans l'espace libre continu, une zone de travail de soudage du dispositif de soudage étant située dans le plan de travail du groupe de sources lumineuses individuelles.

51. Dispositif selon l'une des revendications précédentes, avec référence à la revendication 15, **caractérisé par** un mécanisme de transport de fluide (871) qui est en communication avec un réservoir de fluide et présente un dispositif de transport (872, 873) disposé au moins partiellement dans l'espace continu d'ouverture libre avec une extrémité de transport (874) pour du fluide, au moyen duquel la zone d'usinage (823) peut être alimentée en fluide et/ou du fluide peut être aspiré de la zone d'usinage (823).

52. Dispositif selon la revendication 51, **caractérisé par le fait que** le dispositif de transport comprend un tube de transport (873) dans lequel le fluide est conduit au moins par parties dans la zone d'ouverture libre continue et dont l'extrémité de transport (874) est voisine de la zone d'usinage (823).

53. Dispositif selon la revendication 51 ou 52, **caractérisé par le fait que** l'extrémité de transport est réalisée sous la forme d'une buse (874).

54. Dispositif selon l'une des revendications 51 à 53, **caractérisé par le fait que** l'extrémité de transport (874) est remplaçable.

55. Dispositif selon l'une des revendications 51 à 54, **caractérisé par** un dispositif de mesure de distance (875) pour déterminer la distance entre l'extrémité de transport (874) et la pièce à usiner (801).

56. Dispositif selon la revendication 55, **caractérisé par le fait qu'**au moins l'extrémité de transport (874) est en matériau conducteur de l'électricité et présente un support qui isole électriquement l'extrémité de transport (874) par rapport à la pièce à usiner (801), le dispositif de mesure de distance (875) étant un dispositif de mesure de capacité pour la détermination de la capacité entre l'extrémité de transport (874) et la pièce à usiner (801).

57. Dispositif selon la revendication 56, **caractérisé par le fait que** le tube de transport (873) est en matériau conducteur de l'électricité et est entouré au moins par parties d'une électrode de blindage (877).

58. Dispositif selon l'une des revendications 51 à 57, **caractérisé par** un dispositif (876) pour la génération d'un mouvement relatif axial entre le tube de transport (873) et l'électrode de blindage (877).

59. Dispositif selon la revendication 57 ou 58, **caractérisé par le fait que** l'électrode de blindage (877) est formée d'un tube de blindage coaxial au tube de transport (873).

60. Dispositif selon l'une des revendications 51 à 59, **caractérisé par** un dispositif de positionnement (876) pour la génération d'un mouvement relatif entre l'extrémité de transport (874) et la pièce à usiner (801).

61. Dispositif selon la revendication 60, **caractérisé par le fait que** le dispositif de positionnement (876) comprend un dispositif d'ajustement (896) pour le positionnement précis de l'extrémité de transport (874) par rapport à la pièce à usiner (801).

62. Dispositif selon la revendication 61, **caractérisé par le fait que** le dispositif d'ajustement (896) présente une source lumineuse d'ajustement disposée sur le dispositif de transport (872, 873), dont le rayonnement est guidée de manière collimatée au moins à travers l'extrémité de transport (874) du dispositif de transport (872, 873).

63. Dispositif selon la revendication 62, **caractérisé par le fait que** la source lumineuse est une diode laser (896) travaillant dans la gamme des longueurs d'onde visibles.

64. Dispositif selon l'une des revendications 61 à 63, **caractérisé par le fait que** le fluide est un gaz amené sous haute pression dans la zone d'usinage (823).

65. Dispositif selon l'une des revendications précédentes, **caractérisé par le fait qu'**il est prévu plusieurs groupes de sources lumineuses individuelles (4, 4') coaxiaux à l'axe optique (5).
